(19) Europäisches Patentamt
European Patent Office
Office européen des brevets

(11) EP 0 555 047 B1

(12) **EUROPEAN PATENT SPECIFICATION**

(45) Date of publication and mention
of the grant of the patent:
**14.05.1997 Bulletin 1997/20**

(51) Int Cl.6: **H01L 29/74**, H01L 29/72

(21) Application number: **93300748.6**

(22) Date of filing: **02.02.1993**

(54) **Semiconductor gated switching device**

Schaltungs-Halbleiterbauteil mit Gate

Dispositif semi-conducteur de commutation à commande

(84) Designated Contracting States:
**DE FR GB**

(30) Priority: **03.02.1992 JP 17575/92**

(43) Date of publication of application:
**11.08.1993 Bulletin 1993/32**

(73) Proprietor: **FUJI ELECTRIC CO., LTD.
Kawasaki-shi, Kanagawa-ken (JP)**

(72) Inventors:
• **Sakurai Ken'ya, c/o Fuji Electric Co., Ltd.
Kawasaki-shi, Kanagawa (JP)**
• **Otsuki, Masahito C/O Fuji Electric CO LTD
Kawasagi-shi, Kanagawa (JP)**

(74) Representative:
**Beresford, Keith Denis Lewis et al
BERESFORD & Co.
2-5 Warwick Court
High Holborn
London WC1R 5DJ (GB)**

(56) References cited:
EP-A- 0 159 663          EP-A- 0 433 825
EP-A- 0 477 594          WO-A-92/12541
DE-A- 4 011 509          FR-A- 2 524 711
US-A- 4 604 638          US-A- 4 958 211

• ELEKTRONIK vol. 39, no. 18, 31 August 1990,
München DE, page 52; R. JACOBSEN :
"Leistungsstarke BIMOS-Bausteine in Sicht"

## Description

The present invention relates to a semiconductor device, a circuit including, and a method of operating the same. In particular it relates to semiconductor power devices having two gate electrodes for controlling on/off switching.

The semiconductor device considered herein has the following known features:

a collector region of a first conductive type;
a first base region of opposite second conductive type;
a second base region of the first conductive type disposed in the first base region; and
a first emitter region of the second conductive type disposed in the second base region, wherein the collector region, first base region, second base region and first emitter region define a thyristor;
a first gate electrode insulated from and extending across the first base region, second base region, and first emitter region, to define therewith a first insulated gate transistor; and
a second gate electrode, separate from the first gate electrode, insulated from and extending across said second base region, first emitter region and a second emitter region of said first conductive type disposed in said first emitter region define therewith a second insulated gate transistor.

A semiconductor device having the above mentioned features is described in Elektronic vol. 39 No. 18, page 52 published 31 August 1990.

Recently, the quality of power semiconductor devices has been rapidly enhanced. With regard to, for instance, bipolar transistors, they have been designed so as to have high quality and high withstand voltages and to be able to operate at a high current handling capability. Moreover, there have been proposed intelligent modules having various built-in protection functions. In addition, there have been proposed conductivity-modulation transistors (IGBT) capable of responding at a high speed. These power semiconductor devices have been adopted in small-sized electric appliances which are miniaturised so as to be driven by a battery and to easily carry about or electric motorcars, adoption of which has been investigated from the viewpoint of environmental protection, and partially contribute to electric power-saving. In order to cope with the recent increasingly high demand for the electric power, it has been required for the development of power semiconductor devices which allow a further saving of electric power and reduction of power loss.

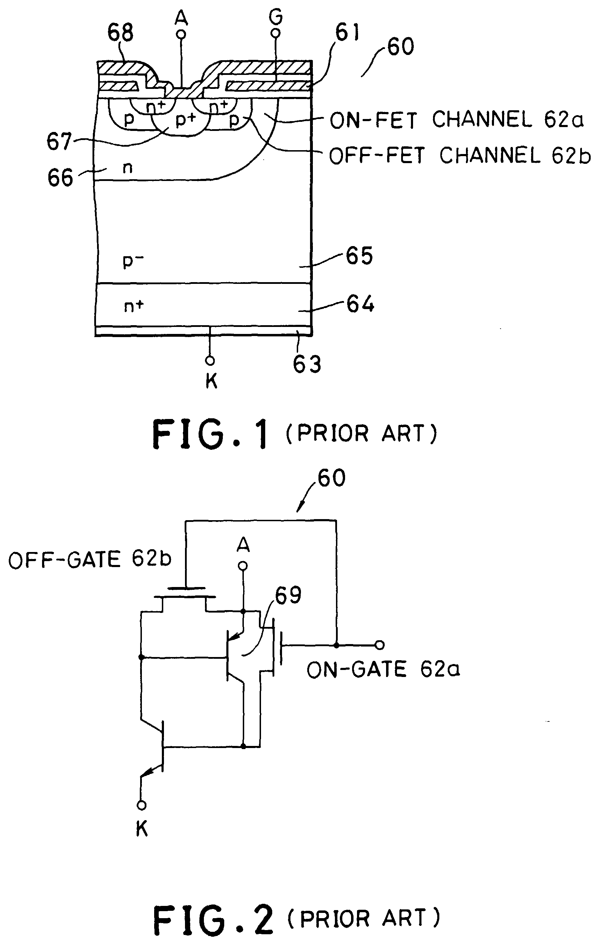

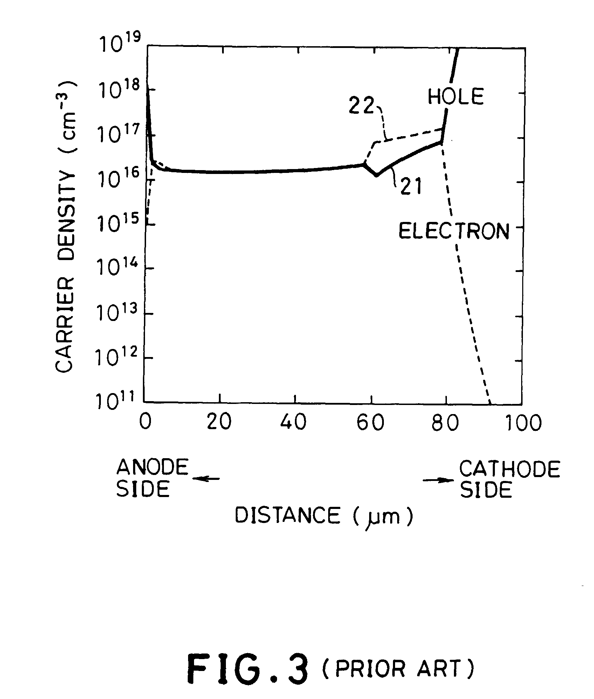

For instance, there have been developed MCT's (MOS controlled·thyristor) for reducing the ON-state voltage through the use of a thyristor structure, for imparting fast operability to devices and for reducing the electric power required for driving these devices. Such an MCT is a device having a structure and an equivalent circuit as shown in Figs. 1 and 2 respectively and is detailed in the article of V.A.K. Temple entitled "MOS controlled thyristors" (IEEE International Electron Device Meeting Digest, 1984). MCT 60 comprises an ON-FET 62a and an OFF-FET 62b controlled by a single gate electrode 61 and when an electric current is passed through ON-FET 62a and OFF-FET 62b is simultaneously shut-off, an npnp thyristor is in the turn-on state, which comprises an $n^+$ -cathode layer 64 provided thereon with a cathode electrode 63, a $p^-$ -base layer 65, an n-base layer 66 and a $p^+$ - anode layer 67 provided thereon with an anode electrode 68. On the other hand, when an electric current is passed through OFF-FET 62b and ON-FET 62a is simultaneously shut-off, $n^-$ base layer 66 and anode electrode 68 are short-circuited , a pnp transistor 69 is in the OFF state and hence this device is in the turn-OFF state. This pnp transistor 69 comprises $p^-$ -base layer 65, n-base layer 66 and $p^+$ -anode layer 67. Since MCT 60 puts the device in the ON state through the action of an MOS in such a manner, the response speed thereof is very high. Further it also puts the thyristor in the ON state and, therefore, the ON-state voltage drop of the device is very low on the order of about 1V. However, as shown in Fig. 3, the carrier densities of holes and electrons present within anode layer 67 and base layers 65 and 66 are high in the thyristor state. For this reason, the turn-off time of this device is quite long on the order of 2 to 3 $\mu$ sec due to such very high carrier densities and thus the loss during this time becomes a problem. In particular, this results in a substantial increase in the electric power loss when the device is used in the high frequency applications.

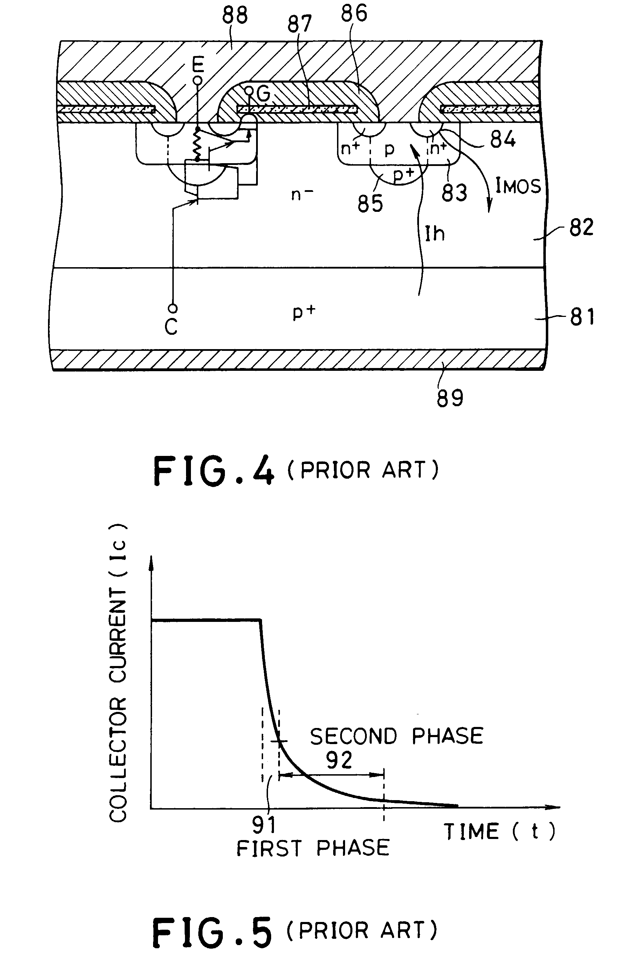

In an IGBT as shown in Fig. 4, on the other hand, the collector current during the turn-off state has a typical wave form as shown in Fig. 5. As seen from Fig. 5, the wave form during the turn-off state comprises a first phase 91 and a second phase 92. First phase 91 corresponds to such a phenomenon that a channel formed by the action of a gate 87 disappears, the supply of electron current from an emitter electrode 88 to an $n^-$ -base layer 82 is interrupted and correspondingly, the current is rapidly reduced instantaneously in proportion thereto. Second phase 92 corresponds to such a phenomenon that the carriers remaining in $n^-$ -base layer 82 migrate through the action of a pnp transistor comprising a $p^+$ -collector layer 81, $n^-$ -base layer 82 and a p-base layer 83 and are reduced due to disappearance of the carriers through recombination within the life time $\tau$ thereof. Reduction of the turn-off time of IGBT, therefore, can be accomplished by reducing the injection level of a hole current or by shortening the carrier life time $\tau$. For this reason, there have been proposed a technique in which an $n^+$ -layer is formed between $p^+$ -collector layer 81 and $n^-$ -base layer 82 to control the injection level of the hole current (see IEEE, IEDM Technical Digest, 4.3 (1983), pp.79-82) and a technique in which the impurity doping concentration of collector layer 81 is controlled. In addition, as methods for shortening the life time $\tau$ of carrier, there has been proposed a technique which makes use of a life time control process such as irradiation with an electron beam or heavy metal diffusion (see IEEE, Trans. Electron Devices, ED-31 (1984), pp. 1790-1795). These techniques make it possible to reduce the fall time during the turn-off state to approximately 200 nsec and to thus obtain a device capable of being operated even at a high frequency. Incidentally, techniques concerning this IGBT are detailed in the article of the inventors of this invention ("New IGBT Modules with Improved Power Loss at High Frequency PWM Mode", Electronica, '90 Munchen).

As has been discussed above in detail, IGBT has an advantage in that it has a short turn-off time, but is a device which has a high ON-state voltage drop in the order of about 2 V and in which it is difficult to reduce the ON-state loss. This is because the density of p-base layer 83 cannot sufficiently be increased to prevent the occurrence of a latch-up state due to operation of a parasitic thyristor. In IGBT, the emitter current $I_E$ is equal to $I_h + I_{MOS}$ as shown in Fig. 4 and if the gain of pnp transistor comprising p-base region 83, an $n^-$ -drift region 82 and $p^+$ -collector region 81 is assumed to be $\alpha_{PNP}$, the following relation can be obtained:

$$I_h = (\alpha_{PNP}/ (1-\alpha_{PNP})) \times I_{MOS}$$

Therefore, the following equation can be obtained:

$$I_E = (1/(1-\alpha_{PNP})) \times I_{MOS}$$

$I_h$ (hole current) and hence the current of IGBT vary depending on the value of $\alpha_{PNP}$. In the foregoing relations, $I_{MOS}$ means an electron current.

One of the most important key technologies for solving the problem of improvement of quality, miniaturization and cost-saving in the field of power electronics, is to reduce the power loss of power devices. This requires the development of a power device having short turn-off time and simultaneously having a low ON-state voltage drop. However, if the same means used in IGBT, i.e., the reduction of carrier life time and formation of an $n^+$ -buffer layer are adopted to reduce the turn-off time in, for instance, MCT discussed above, the ON-state voltage drop increases as in the case of IGBT. For this reason, it is not possible to make use of the advantage of MCT, i.e., low ON-state voltage drop. Moreover, it is necessary to instantaneously extract the carriers accumulated in MCT in order to reduce the turn-off time. However this requires the formation of an additional MOS gate for extracting the current and the driving power must be increased to extract the carriers. Further, an instantaneous extraction of a large current requires the use of a MOS gate having a low ON-state resistance. It is presently possible to make the most use of the prop-

erties of each device such as low ON-state voltage drop or short turn-off time separately, but the development of a device having these properties in combination is very difficult.

An alternative MOS controlled thyristor device is described in German Patent Application DE-A-4011509 having a collector region, first and second base regions, a first emitter region defined in the second base region, and second emitter regions defined in the first emitter region. An insulated common gate electrode is provided and overlaps the second base region, the first emitter region, and respective second emitter regions each side of the first emitter region. This device is configured as a bidirectional switch and has second collector regions defined within the collector region first mentioned. A second common insulated gate electrode is provided on the collector side of the device. This overlaps the first base region, the collector region, and the second collector regions each side of the collector region. An FET is thus provided providing a switchable internal current path between the first base region and the collector region.

International patent application No. WO92/12541 published 23 July 1992, is mentioned with reference to Article 54(3) EPC. There is therein disclosed an MCT device having the equivalent circuit as described with reference to figure 2 of the accompanying drawings. The off-gate transistor is an isolated structure, defined in and separated from the second base region by an oxide layer.

European patent application EP-A-0477594, published 1 April 1992, also is mentioned with reference to Article 54(3) EPC. There is therein disclosed an MCT device having a first gate electrode insulated from and extending across a second base region and first and second emitter regions to define a first FET. There is provided a second FET which is isolated and provides a switchable connection between the first emitter region and an electrode in electrical contact with the second emitter region.

Accordingly, in the light of the foregoing problems, an object of the present invention is to provide a new power device which makes the most use of the characteristic peculiar to MCT, i.e., low ON-state voltage drop and the characteristic peculiar to IGBT, i.e. short turn-off time.

To accomplish the foregoing object, the inventors of this invention have developed a new device which serves as a thyristor during ON-state like MCT and as a transistor during OFF state like IGBT.

The semiconductor device in accordance with the invention, while having the known features already mentioned, is characterised by:

a third gate electrode, coextensive with the first gate electrode insulated from and extending across the second base region, first emitter region and a second emitter region of the first conductive type disposed in the first emitter region to define therewith a third insulated gate transistor.

This semiconductor device has a thyristor structure which comprises a first conductive type collector region, a second conductive type base region, a first conductive type base region and a second conductive type emitter region, and comprising; a first FET which can inject majority carriers into the second conductive type base region; and a second FET which can be opened and closed independently of the first FET and capable of extracting majority carriers from the first conductive type base region.

This semiconductor device has in addition to the second FET, a third FET having a gate electrode common to the first FET and capable of extracting majority carriers from the first conductive type base region.

In the embodiments discussed in detail hereinbelow, the first conductive type emitter region is formed within the first conductive type base region in addition to the foregoing second conductive type emitter region. In use, an emitter voltage is simultaneously applied to the first and second conductive type emitter regions. More specifically, the first conductive type emitter region is formed within the second conductive type emitter region. A gate insulating film and a second gate electrode of the second FET are formed on the surface of the first conductive type emitter region. The second conductive type emitter region and the first conductive type base region. The second conductive type emitter region serves as a channel region. Moreover, the first gate electrode common to the first and third FET's is formed on the surface of the first conductive type emitter region, the second condutive type emitter region the first conductive type base region and the second conductive type base region with a gate insulating film therebetween. The first conductive type base region serves as a channel region for the first FET and the second conductive emitter region serves as a channel region for the third FET.

It is preferred that the first conductive type base region be doped at a dose of not less than $2 \times 10^{13}$ cm$^{-2}$ and not more than $1 \times 10^{14}$ cm$^{-2}$ and that the second conductive type emitter region be doped at a dose of equal to or more than that for the first conductive type base region and not more than $1 \times 10^{14}$ cm$^{-2}$.

Moreover, the first conductive type base region may comprise a first conductive type well having a high dose and a first conductive type peripheral portion shallower than the depth of the well. In this case, if the first conductive type well of high dose is formed by surface-diffusion, the dose of the well is preferably not less than $1 \times 10^{13}$ cm$^{-2}$ and not more than $5 \times 10^{15}$ cm$^{-2}$. Alternatively, if the first conductive type well of high dose is formed as a buried layer, the dose thereof is preferably not less than $1 \times 10^{12}$ cm$^{-2}$ and not more than $3 \times 10^{14}$ cm$^{-2}$. Moreover, if the first conductive type well of high dose is formed as a buried layer, the edge of a diffusion window of the first conductive type well of a high dose is positioned within a region defined between the inner edge of the first conductive type emitter region and the inner edge of the second electrode of the second FET.

The second conductive type emitter region may likewise comprise a second conductive type well having a high dose and a second conductive type peripheral portion shallower than the well. In this case, the surface concentration of the second conductive type well having a high dose is preferably not less than $5 \times 10^{17}$ cm$^{-3}$ and not more than $5 \times 10^{20}$ cm$^{-3}$. In addition, the diffusion depth of the second conductive type well of high dose is preferably not less than the diffusion depth of the second conductive type peripheral portion and not more than 1.9μm. Moreover, it is preferred that the length of the first gate electrode be not less than 20μm and not more than 30μm, that the length of the second gate be not less than 1μm and not more than 8μm and that the contact length of an emitter electrode which conductively comes in contact with the first conductive type emitter region and the second conductive type emitter region be not less than 1μm and not more than 6μm.

Moreover, a shallow second conductive type counter-doping region may be formed on the surface of the first conductive type base region concerning the first FET. Further, a first conductive type doping region of a high dose may be formed on the surface of the foregoing first conductive type base region concerning the second FET.

In the foregoing semiconductor device, majority carriers in the second conductive type emitter region are injected into the second conductive type base region when the first FET is put in operation and, in response thereto, minority carriers in the first conductive type collector region are injected into the second conductive type base region. Therefore, the transistor comprising the first conductive type collector region, the second conductive type base region and the first conductive type base region is in ON state. Thus, majority carriers are injected into the first conductive type base region and simultaneously, the transistor comprising the second conductive type base region, the first conductive type base region and the second conductive type emitter region is in the ON state. The thyristor comprising the first conductive type collector region, the second conductive type base region, the first conductive type base region and the second conductive type emitter region is accordingly in the ON state. Consequently, the ON-state voltage drop can be reduced.

On the other hand, if the second FET for mode-switching is put in operation while the first FET is in the ON state, majority carriers in the first conductive type base region flow out of the first conductive type emitter region through the second FET and as a result, the transistor comprising the second conductive type base region, the first conductive type base region and the second conductive type emitter region is in the OFF state. For this reason, the device is transferred to a transistor state like IGBT through the thyristor state and this results in a decrease of the carrier density in the device.

This allows the reduction of the turn-off time observed when the first FET is thereafter in the OFF state and this semiconductor device is in the OFF state.

Since the device comprises a third FET, the device is enhanced in the effect of extracting excess carriers from the first conductive type emitter region when both second and third FET's are in operation.

Since the first gate electrode of the first MISFET is formed in such a manner that it covers the first emitter layer formed within the second conductive type emitter region and that it extends over the second conductive type emitter region, the first conductive type base region and the second conductive type base region, majority carriers present in the second conductive type emitter region can be injected into the second conductive type base region during the ON state, while minority carriers are extracted from the first conductive type base region and injected into the first emitter layer during the OFF state to thus further reduce the turn-off time. Since the third FET and the first FET have a common gate electrode, the third FET is in the ON state when the first FET is in the OFF state. Separately, the ON-state voltage drop can be controlled to a low level and the controllable carrier can be increased if the first controllable type base region comprises a first conductive type well of high dose and a first conductive type peripheral portion shallower than the well. Alternatively, if the second conductive type emitter region comprises a second conductive type well of high dose and a second conductive type peripheral portion shallower than the well, the ON-state voltage drop can be further reduced and the controllable current can further be increased. In addition, the formation of the shallow second conductive type counter-doping region on the surface of the first conductive type base region permits the reduction of realize such an equivalent circuit structure, a first conductive type emitter region is formed within the first conductive type base region in addition to the foregoing second conductive type emitter region, in which an emitter voltage is simultaneously applied to the first and second conductive type emitter regions. More specifically, the first conductive type emitter region is formed within the second conductive type emitter region. a second gate electrode of the second MISFET is formed on the surface of the first conductive type emitter region, the second conductive type emitter region and the first conductive type base region though a gate insulating film in which the second conductive type emitter region serves as a channel region. Moreover, the first gate electrode common to the first and third FET's is formed on the surface of the first conductive type emitter region, the second conductive type emitter region, the first conductive type base region and the second conductive type base region through a gate insulating film in which the first conductive type base region serves as a channel for the first FET and the second conductive type emitter region serves as a channel region for the third FET. In such case, it is preferred that the first conductive type base region be doped at a dose of not less than $1 \times 10^{14}$ cm$^{-2}$ and that the second conductive type emitter region be doped at a dose of equal to or more than that for the first conductive type base region and not more than $1 \times 10^{14}$ cm$^{-2}$.

The above and other objects, effects, features and advantages of the present invention will become more apparent from the following description of embodiments thereof taken in conjunction with the accompanying drawings.

Fig. 1 is a cross sectional view showing an embodiment of the structure of MCT;

Fig. 2 is a circuit diagram showing the equivalent circuit of the MCT;

Fig. 3 is a graph illustrating the carrier density of the MCT;

Fig. 4 is a cross sectional view showing an embodiment of the structure of IGBT;

Fig. 5 is a waveform chart illustrating the turn-off waveform of the IGBT;

Fig. 6 is a cross sectional view showing the structure of a semiconductor device according to Embodiment 1 of the present invention;

Fig. 7 is a plan view showing the structure of the semiconductor device according to Embodiment 1;

Fig. 8 is a circuit diagram showing the equivalent circuit of the semiconductor device according to Embodiment 1;

Fig. 9 is a diagram for explaining the operating condition of the semiconductor device according to Embodiment 1;

Fig. 10A is a cross sectional view of the semiconductor device according to Embodiment 1, showing the passage of current flowing through the device in the thyristor state;

Fig. 10B is a cross sectional view of the same semiconductor device, showing the passage of current flowing through the device in the transistor state;

Fig. 11A is a graph illustrating the carrier density of the semiconductor device according to Embodiment 1 which is in the thyristor state;

Fig. 11B is a graph illustrating the carrier density of the same semiconductor device which is in the transistor state;

Fig. 12 is a graph illustrating the output characteristics of the semiconductor device according to Embodiment 1;

Fig. 13 is a graph illustrating the switching characteristics of the semiconductor device according to Embodiment 1;

Fig. 14 is a graph illustrating the relation between the dose of the p-base layer the semiconductor device according to Embodiment 1 and the ON-state voltage drop in the thyristor state or the latch-up current in the transistor state;

Fig. 15 is a graph illustrating the relation between the dose of the n-emitter layer of the semiconductor device according to Embodiment 1 and the ON-state voltage drop in the thyristor state or the latch-up current in the transistor state;

Fig. 16 is a cross sectional view showing the structure of a semiconductor device according to Embodiment 2 of the present invention;

Fig. 17 is a graph illustrating the relation between the dose of the $P^+$ -well formed through the surface diffusion technique and the latch-up current in the transistor state, observed on the semiconductor device according to Embodiment 2;

Fig. 18 is a graph illustrating the relation between the dose of the $P^+$ -well formed through the surface diffusion technique and the ON-state voltage drop in the transistor state, observed on the semiconductor device according to Embodiment 2;

Fig. 19 is a graph illustrating the relation between the $P^+$ -well formed as a buried layer and the ON-state voltage drop in the thyristor state or the latch-up current in the transistor state, observed on the semiconductor device according to Embodiment 2;

Fig. 20 is a cross sectional view showing the relative relation between the edge position X of the diffusion window of the $P^+$ -well formed as a buried layer and the gate electrode, observed on the semiconductor device according to Embodiment 2;

Fig. 21 is a graph illustrating the relation between the edge position X of the diffusion window and the ON-state voltage drop in the thyristor state or the latch-up current in the transistor state, observed on the semiconductor device according to Embodiment 2;

Fig. 22 is a cross sectional view showing the structure of the semiconductor device according to Embodiment 3 of the present invention;

Fig. 23 is a graph illustrating the relation between the surface concentration of the $n^+$ -well layer and the ON-state voltage drop in the thyristor state or the latch-up current in the transistor state, observed on the semiconductor device according to Embodiment 3;

Fig. 24 is a graph illustrating the relation between the diffusion depth of the $n^+$ -well and the ON-state voltage drop in the thyristor state or the latch-up current in the transistor state, observed on the semiconductor device according to Embodiment 3;

Fig. 25 is a cross sectional view illustrating the gate length $L_{g1}$ of the first gate electrode, the gate length $L_{g2}$ of the second gate electrode and the contact length $L_E$ of the emitter electrode, in the semiconductor device according to Embodiment 3;

Fig. 26 is a graph illustrating the relation between the gate length $L_{g1}$ and the latch-up current in the transistor state or the ON-state voltage drop in the transistor state, observed on the semiconductor device according to Embodiment 3;

Fig. 27 is a graph illustrating the relation between the gate length $L_{g2}$ and the latch-up current in the transistor state or the ON-state voltage drop in the thyristor state, observed on the semiconductor device according to Embodiment 3; and

Fig. 28 is a graph illustrating the relation between the contact length $L_E$ of the emitter electrode and the latch-up current in the transistor state or the ON-state voltage drop in the thyristor state, observed on the semiconductor device according to Embodiment 3.

Embodiment 1

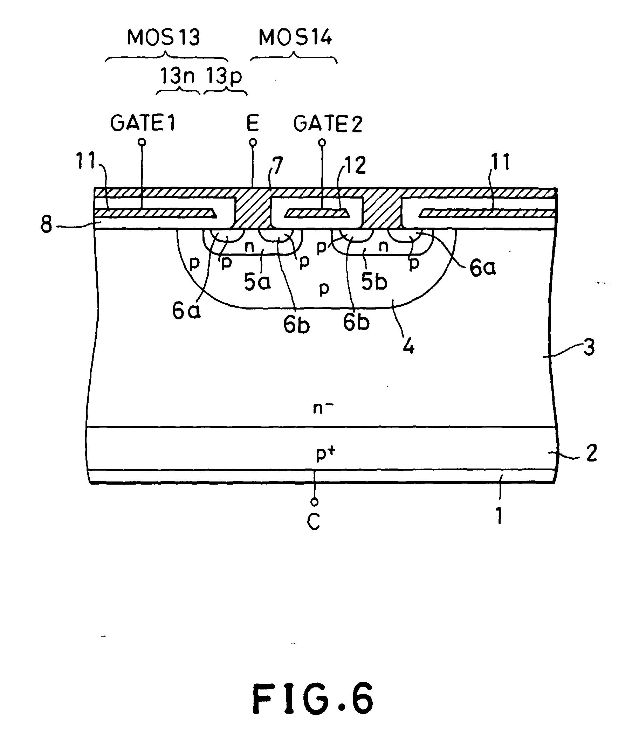

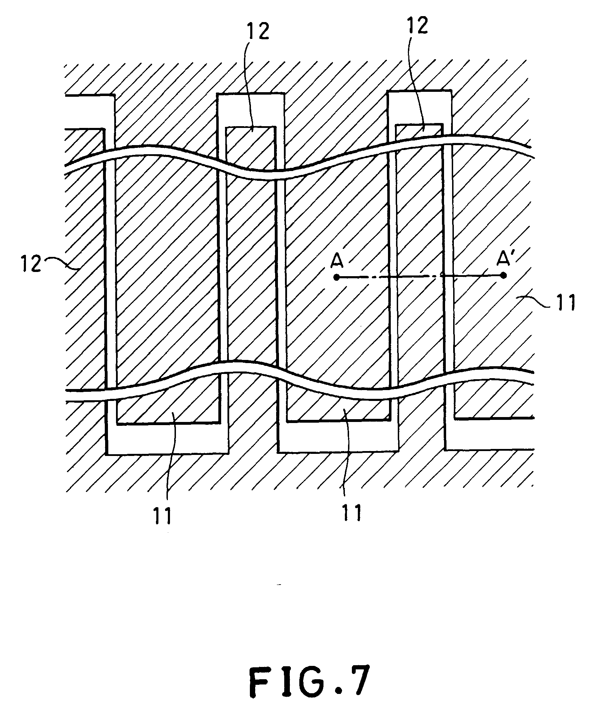

Fig. 6 is a cross sectional view taking along the line A-A' of the plan view shown in Fig. 7 and shows the cell structure of a semiconductor device equipped with a double gate comprising first and second gates according to this embodiment 1. The semiconductor device according to embodiment 1 comprises a $p^+$ -substrate, as a collector layer 2, provided thereon with a collector electrode 1 formed on the back face thereof and an $n^-$ -base layer 3 which is formed on collector layer 2 through the epitaxial growth technique or the like. A p -base layer 4 as a well-like p or $p^+$ -diffusion layer is formed on the surface of $n^-$ -base layer 3. Further, emitter layers 5a and 5b are formed on the inner surface of this p -base layer 4 as two n-type wells. In addition, two $p^+$ -emitter layers 6a and 6b are formed on the inner surfaces of these n-emitter layers 5a and 5b respectively. An emitter electrode 6 is connected to these two $p^+$ -emitter layers 6a and 6b and to n-emitter layers 5a and 5b. Moreover, a first gate electrode 11 (common gate electrode) which constitutes a first MOS 13n and a third MOSFET 13p are formed in such a manner that it covers $p^+$ -emitter layer 6a and that it extends over the surfaces of n-emitter layer 5a or 5b, p-base layer 4 and $n^-$ -base layer 3, through a gate-oxide film 8. On the other hand, a second gate electrode 12 which constitutes a second MOS 14 is formed in such a manner that it covers $p^+$ -emitter layer 6b and that it extends over the surface of n-emitter layer 5a or 5b and p-base layer 4, through a gate-oxide film 8. First and second gate electrodes 11 and 12 are separately and independently formed and each has such a structure that a gate-control voltage can independently be applied thereto. More specifically, as shown in, for instance, Fig. 7, first and second gate electrode 11 and 12 are formed in a threadlike shape.

Since the structures of the devices with respect to these two n-emitter layers 5a and 5b are identical to one another, the device will be explained below with reference to only n-emitter layer 5a. MOS 13 comprising gate electrode 11 can be divided into an n-channel type first MOS 13n which comprises n-emitter layer 5a, p-base layer 4 and $n^-$ -base layer 3 and a p-channel type third MOS 13p which comprises $p^+$ -emitter layer 6a, n-emitter layer 5a and p-base layer 4. On the other hand, second MOS 14 comprising gate electrode 12 is a p-channel type MOSFET.

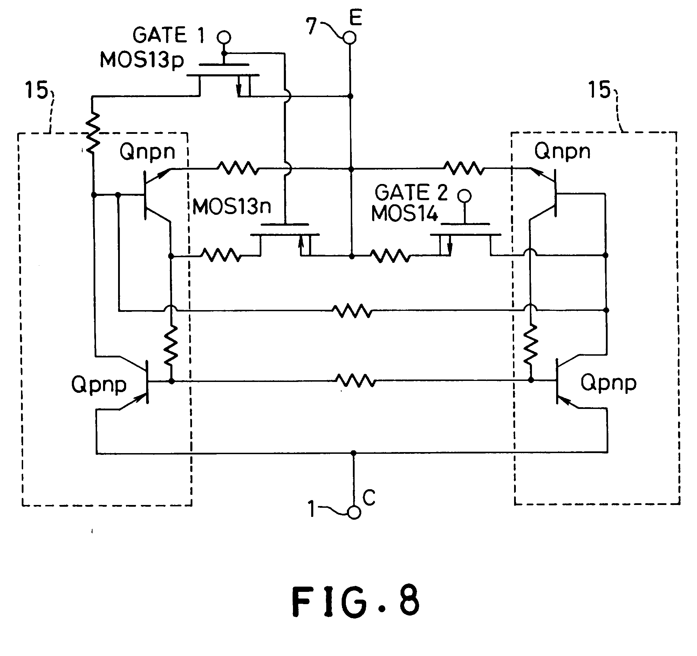

Fig. 8 shows the equivalent circuit of this device. In this device, n-emitter layer 5a, p-base layer 4 and $n^-$

-base layer 3 form an npn transistor $Q_{npn}$. In addition, p-base layer 4, n$^-$-base layer 3 and p$^+$ -collector layer 2 form a pnp transistor $Q_{pnp}$. Thus, these transistors $Q_{npn}$ and $Q_{pnp}$ form a thyristor 15. There are depicted two thyristors around a collector 1 and an emitter 7 positioned at the center of the equivalent circuit shown in Fig. 8, but they are separately shown only for convenience's sake and these thyristors are identical to one another.

In addition to these transistors $Q_{npn}$ and $Q_{pnp}$, first MOS 13 is designed to connect the collector of the transistor Qnpn and the base of the transistor $Q_{pnp}$ to an emitter electrode 7. Moreover, third MOS is designed to connect the base of the transistor $Q_{npn}$ to emitter electrode 7 through a p$^+$ -emitter layer 6a. On the other hand, second MOS 14 is designed to connect the base of the transistor $Q_{npn}$ to emitter electrode 7 through a p$^+$ -emitter layer 6b.

In this device having the structure discussed above, if high voltages are applied to a gate electrode 11 and second gate electrode 12, first MOSFET 13n is in the ON state while second MOSFET 14 and third MOSFET 13p are still in the OFF state. More specifically, the surface of n-emitter layer 5a right under gate electrode 11 serves as an n$^+$ -accumulation layer, the surface of p-base layer 4 serves as an n-inversion layer and emitter electrode 7 is connected to n$^-$ -base layer 3 through n-emitter layer 5a, n$^+$ - accumulation layer existing on the surface of the emitter layer and the n-inversion layer existing on the surface of p-base layer 4. Therefore, electrons are injected, through emitter electrode 7, into n$^-$ -base layer 3 serving as a drift region and, in response thereto, holes present in p$^+$ -collector layer 2 are likewise injected. This means that the pnp transistor $Q_{pnp}$ is in the ON state. Moreover, the hole current of this transistor $Q_{pnp}$ serves as a base current of the transistor $Q_{npn}$ which comprises n-emitter layer 5a, p-base layer 4 and n$^-$ -base layer 3 and, therefore, the transistor $Q_{npn}$ is in the ON state. In other words, thyristor 15 comprising p$^+$ - collector layer 2, n$^-$ -base layer 3, p-base layer 4 and n-emitter layer 5a is thus in the ON state, carriers are present in the device in a high concentration and accordingly, the device has a low resistance. As has been discussed above, if high voltages are applied to gate electrode 11 and gate electrode 12 of this device, only first MOSFET 13n is in the ON state, majority carriers (electrons) are injected into n$^-$ -base layer 3 and correspondingly, a thyristor state can be obtained as in the case of MCT discussed above. Therefore, this device serves as a power device having a low ON-state voltage drop. In this respect, first MOSFET 13n serves as a MOSFET for putting the thyristor in operation.

At this ON state of the thyristor if a negative potential is applied to gate electrode 12 of second MOS 14 while maintaining first gate electrode 11 at a high potential, second MOS 14 is in the ON state. In other words, the surface of n-emitter layer 5a just under gate electrode 12 is inverted into a p-type one and a short circuit is formed between p-base layer 4, the surface of n-emitter layer 5a which is inverted into p-type one and p$^+$ -emitter layer 6b. For this reason, the hole current injected through p$^+$ -collector layer 2 is discharged to emitter electrode 7 through p-base layer 4 and p$^+$-emitter layer 6b. Therefore, the transistor $Q_{npn}$ comprising n-emitter layer 5a, p-base layer 4 and n$^-$ -base layer 3 is in the OFF state. As a result, the thyristor operation is disappeared and a transistor state in which only the transistor $Q_{pnp}$ comprising p-base layer 4, n$^-$-base layer 3 and p$^+$ -collector layer 2 is established. This state is identical to the operating state of IGBT explained above and accordingly, this corresponds to the state in which the density of carriers present in the device is reduced. Thus, there can be reduced the time required for sweeping carriers during the OFF state observed when a negative potential, first MOSFET 13n is in the OFF state and third MOSFET and 13p is in the ON state. More specifically, the injection of majority of carriers (electrons) into n$^-$ -base layer 3 is interrupted, second MOS 14 extracts majority of carriers (holes) from p-base layer 4. Simultaneously, p-base layer 4 is connected to p$^+$ -emitter layer 6a through the inversion layer formed on the surface of n-emitter layer 5a and accordingly, majority carriers (holes) are extracted from p-base layer 4. Therefore, holes remaining in p-base layer 4 are rapidly extracted by emitter electrode 7 through the action of second MOSFET 14 and third MOSFET 13p and correspondingly the turn-off time can further be shortened. In this respect, third MOSFET 13p extracts holes near the periphery of p-base layer 4 while second MOSFET 14 extracts holes present at the center of p-base layer 4.

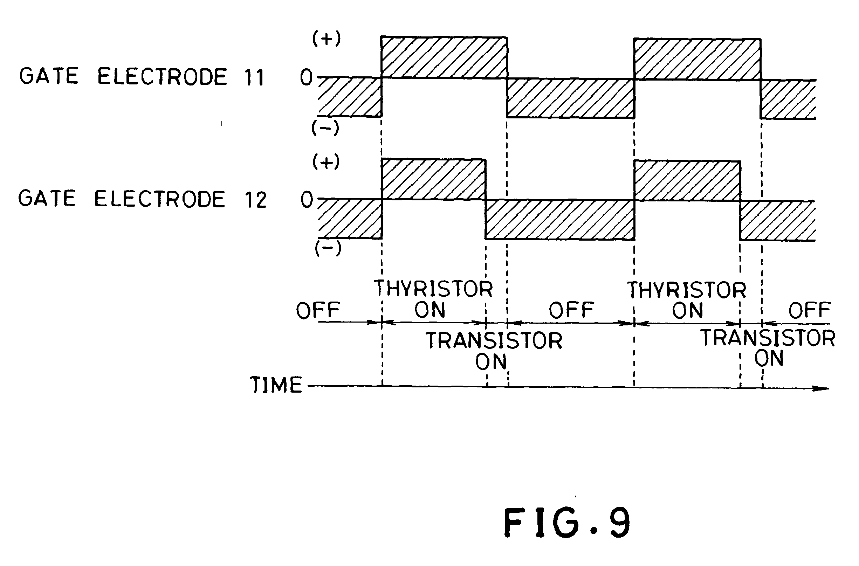

Fig. 9 shows gate-control voltages applied to first gate electrodes 11 and second gate electrode 12. As Shown in Fig. 9, if high voltages are first applied to gate electrodes 11 and 12, this device is in the ON state and the device which is in a thyristor state shows a low ON-state voltage drop on the order of about 1.5V. On the other hand, the device is transferred to a transistor state when a negative potential is applied to gate electrode 12 while a high voltage is still applied to gate electrode 11. When, at this state, a negative potential is applied to gate electrode 11 while maintaining gate electrode 12 at a negative potential, this device is in the OFF state within a short turn-off time on the order of about 1.0μ sec. Moreover, the transfer of the thyristor state to the transistor state is completed within a time of not more than about 0.5μ sec. As has been explained above, this device is in the ON state at a low ON-state voltage drop like MCT and the device is in the OFF state within a short turn-off time like IGBT. Thus, this device serves as a power device having a low switching loss even in the high frequency applications through the repeated alternating switching between the thyristor state and the transistor state as shown in Fig. 9.

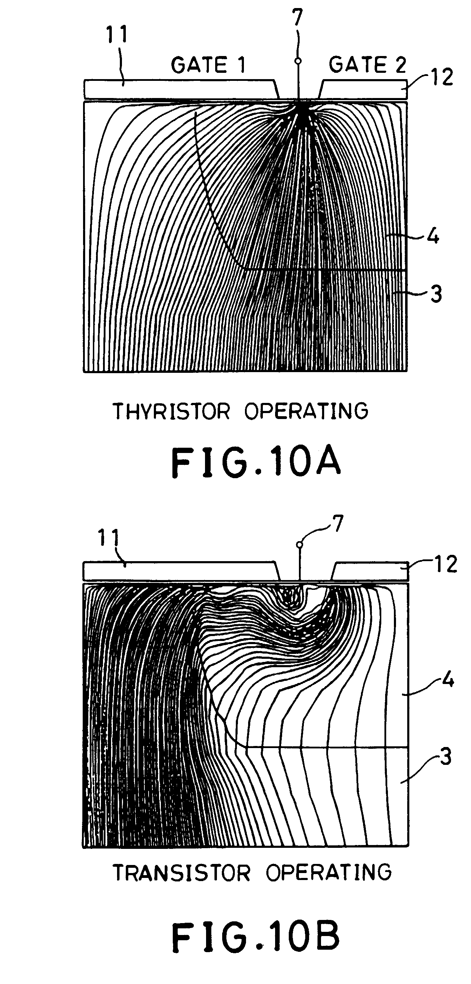

The current flow and carrier distribution in the thyristor and transistor states will be explained below. Figs. 10A and 10B are diagrams showing current flows in the thyristor state and the transistor state respectively. In the thyristor state (Fig. 10A), a hole current and an electron current are united and pass through, in order, p-base layer 4, $n^-$-base layer 3 and emitter electrode 7 to establish a thyristor mode. On the other hand, in the transistor state, a hole current passes through p-base layer 4 and discharged into emitter electrode 7 through MOS 14, while an electron current passes through $n^-$-base layer 3 and discharged into emitter electrode 7 through MOS 13n as in the case of IGBT.

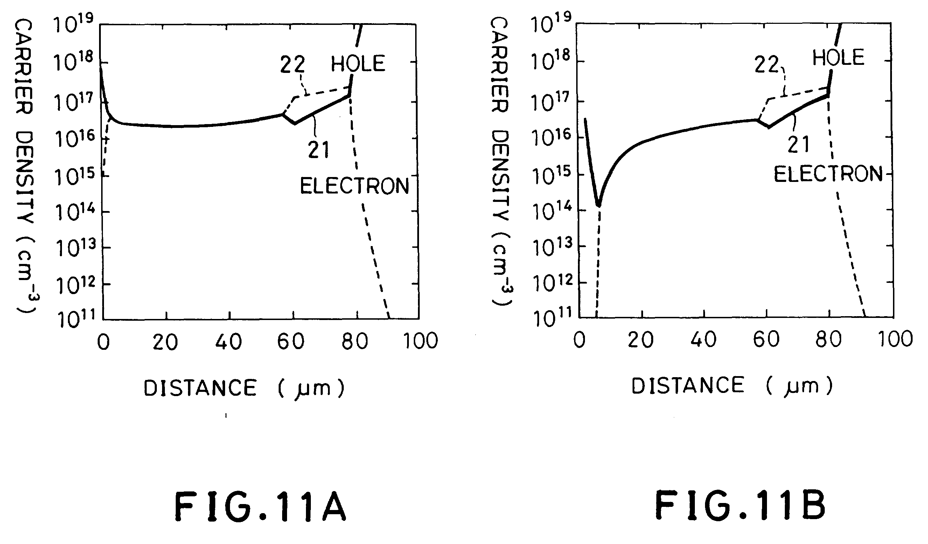

Figs. 11A and 11B are diagrams showing carrier densities in the thyristor and transistor states respectively. These figures show results obtained by simulating hole density 21 and electron density 22 over a region extending from the surface of the semiconductor device according to this embodiment, on which the emitter electrode is formed to, the back face thereof on which the collector electrode is formed. In these figures, the carrier density of holes or electrons is plotted as ordinate and the distance form the surface of the semiconductor device as abscissa. Fig. 11A shows the carrier density of the device which is in the thyristor state and the densities of both carriers distributing on the region extending form the surface of the device to p-base layer 4 and $n^-$-base layer 3 are high levels on the order $10^{16}$ to $10^{17}/cm^3$. Incidentally, $p^+$-collector layer 2 which is the back face of the semiconductor device has a high density 21 of holes as major carriers and a low electron density 22, which in the transistor state as shown in Fig. 11B, the carrier density is reduced to about $10^{14}/cm^3$ in the vicinity of the boundary between p-base layer 4 and $n^-$-base layer 3. The thyristor state is transferred to the transistor state in this way and accordingly, the carrier density within the device is reduced. This allows the shortening of the turn-off time. Thus, the turn-off time of this device can be shortened as in the case of IGBT.

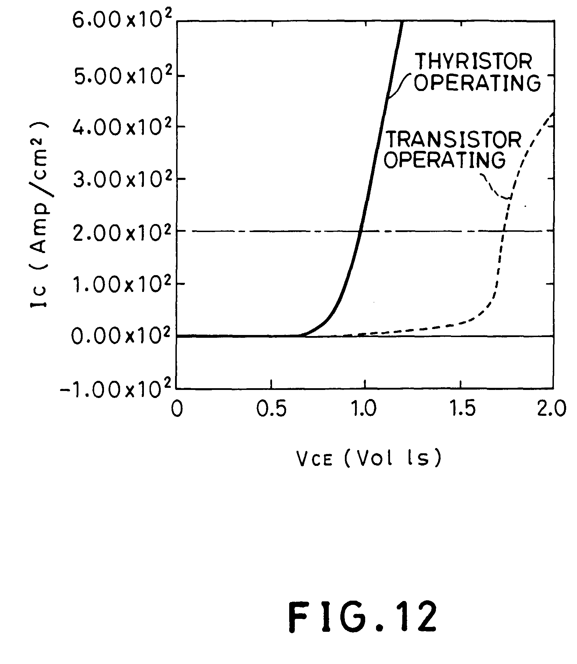

Fig. 12 shows the results obtained by simulating the ON-state voltage drop in this device. If the ON-state voltage drop $V_{on}$ is assumed to be the collector · emitter voltage $V_{CE}$ at which the collector current Ic reaches 200 $A/cm^2$, $V_{on}$ in the thyristor state is about 1.0 V while that in the transistor state is about 1.8 V. Thus, this device makes it possible to control the ON-state voltage drop to a low level by realizing a thyristor state when the device is put in operation.

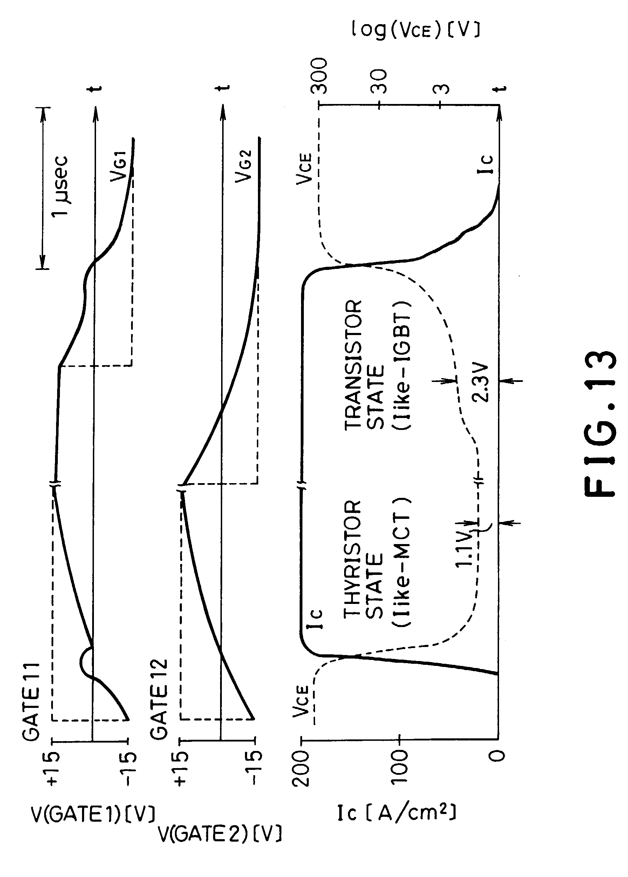

Fig. 13 shows gate voltages of gates 11 and 12 concerning the ON-operation and OFF-operation of this device and variations in the collector current Ic and the collector · emitter voltage $V_{CE}$ of this device. The operation of this device in each state is herein omitted since it have been discussed above in detail, but when a high potential is applied to gates 11 and 12, this device undergoes a thyristor operation at a fast speed corresponding to the turn-off time on the order of $0.3 \mu$ sec and establishes a low ON-state voltage drop and when a negative voltage is then applied to gate 12, the device is transferred from the thyristor state to the transistor state and this transfer is completed within a time not more than about

$0.5 \mu$ sec. Thereafter, turn-off can be performed within a short fall time on the order of $0.3 \mu$ sec.

As has been explained above, the device according to this embodiment is a completely novel device which can realize a thyristor state corresponding to MCT and a transistor state corresponding to IGBT through the use of two independent gate electrodes 11 and 12. As techniques for imparting high quality to devices such as MCT and IGBT, there have been proposed a method for speeding up of these devices and for reducing the electric power required for driving the same through the use of MOS independent gate devices; a method for reducing the ON-state voltage drop while making use of a thyristor structure; and a method for imparting high quality to these devices through combinations of a variety of device structures. However, there has not yet been developed any device which can substantially reduce the ON-state voltage drop and can simultaneously improve the trade off the switching time significantly. On the contrary, the device of the present invention has been developed on the basis of the new concept such that one device is transferred to different two states each favorable for the ON or OFF state thereof. Thus, the present invention can provide a high quality power device having a low ON-state voltage drop comparable to MCT and a short switching time comparable to IGBT.

In respect of these elements having the foregoing structure, it is very important to optimize the impurity doping distribution in both p-base layer 4 and n-emitter layers 5a and 5b (5). More specifically, when first MOSFET 13 n is in the ON state, in the thyristor state, the amount of electrons injected from n-emitter layer 5 into p-base layer 4 is greatly affected by the amount of impurity present in p-base layer 4 and n-emitter layer 5. In other words, an increase in the amount of impurity in n-eimtter layer 5 accompanies an exponential increase in the amount of the injected electrons, while an increase in the amount of impurity present in p-base layer 4 substantially limits the amount of electrons injected into p-base layer 4. For this reason, the ON-state voltage drop of the thyristor can be reduced by increasing the amount of impurity present in n-emitter layer 5 an simultaneously decreasing the amount of impurity in p-base layer 4. On the other hand, the hole current flows through the lower part of n-emitter layer 5 in the transistor state as shown in Fig. 10B. Therefore, if the impurity concentration in p-base layer 4 is low, a latch-up phenomenon is caused. In the latch-up phenomenon, the bipolar transistor $Q_{npn}$ comprising n-emitter layer 5, p-base layer 4 and $n^-$-base layer 3 is in the ON state due to a voltage drop which is resulted from a parasitic resistance of p-base layer 4 and the transistor state is transferred to a thyristor state. Therefore, the latch-up phenomenon observed during the transistor state can be suppressed by increasing the impurity concentration in p-base layer 4. For this reason, the impurity concentrations in p-base layer 4 and n-emitter layer 5 must be optimized so that the ON-state voltage drop in the thyristor state is maintained at a low level and simultaneously the latch-up phenomenon during the transistor state can be eliminated.

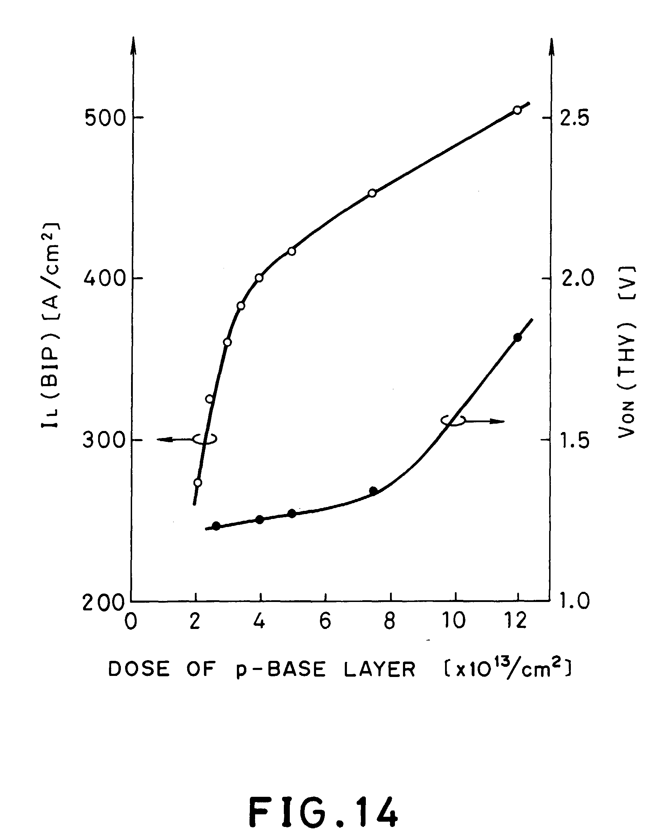

The effect of the impurity-distribution in p-base layer 4 on characteristics of the element was evaluated by device-simulation using a semiconductor substrate composed of a p-type collector layer 2 having a resistivity of 0.01 $\Omega \cdot$ cm; a $n^+$ -type buffer layer formed on the p-type collector layer 2 and having a resistivity of 0.1 $\Omega \cdot$ cm and a thickness of 20$\mu$m; and an n-type layer 4 formed by the epitaxial growth method on the $n^+$ -buffer layer and having a resistivity of 40 $\Omega \cdot$ cm and a thickness of 60$\mu$m. Fig. 14 is a graph illustrating the relation between the dose of p-base layer 4 and the ON-state voltage drop in the thyristor state or the latch-up current (the controllable current observed until the latch-up phenomenon take place) in the transistor state, observed when an n-emitter layer 5 having a surface concentration of 1 $\times$ $10^{17}$ cm$^{-3}$ and a diffusion depth of 1$\mu$m is formed. In this case, the diffusion depth of p-base layer 4 is 8$\mu$m. As seen from this figure, if the dose of p-base layer 4 is lowered, the value of the ON-state voltage drop $V_{ON}$ is reduced, but the latch-up current $I_L$ is likewise reduced and, therefore, the latch-up phenomenon is liable to take place. Since the use of the device as a power device requires a latch-up current $I_L$ of at least about 300Acm$^{-2}$, the lower limit of the dose for p-base layer 4 is 2 $\times$ $10^{13}$ cm$^{-2}$ If the dose is not less than the lower limit, a sufficient latch-up current can be ensured and a device having a high current capacity can be obtained. On the other $V_{ON}$ hand, if the dose is too high, the ON-state voltage drop in the thyristor state increases. If the ON-state voltage drop of the device of this Embodiment is assumed to be 1.5V while taking into consideration the fact that the ON-state voltage drop of IGBT is about 1.7V, the upper limit of the dose for p-base layer 4 is 1 $\times$ $10^{14}$ cm$^{-2}$. In addition, if the dose of p-base layer 4 is equal to 1 $\times$ $10^{14}$ cm$^{-2}$, the threshold voltage of first MOSFET 13n exceeds 10V and this leads to an increase of the gate-control voltage. Thus, a device having a high current capacity (sufficient resistance to latch up) and a low ON-state voltage drop can be realized by limiting the dose of p-base layer 4 to not less than 2 $\times$ $10^{13}$ cm$^{-2}$ and not more than 1 $\times$ $10^{14}$ cm$^{-2}$.

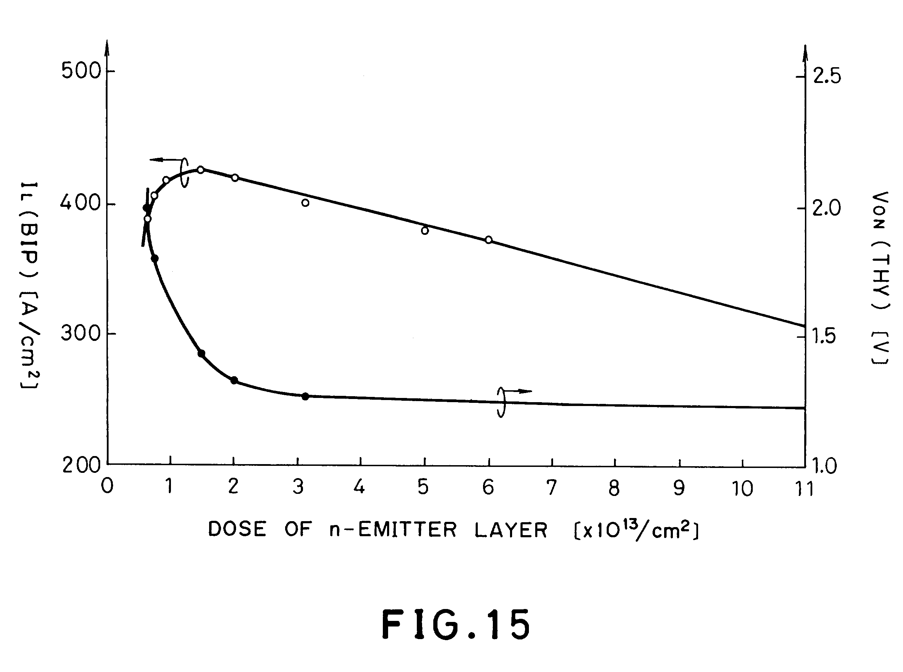

Fig. 15 is a graph illustrating the relation between the dose of n-emitter layer 5 and the ON-state voltage drop in the thyristor state or the latch-up current (the controllable current observed until the latch-up phenomenon takes place) in the transistor state, observed when a p-base layer 4 having a dose of 1.25 $\times$ $10^{13}$ cm$^{-2}$ is formed. As seen from this figure, if the dose of n-emitter layer 5 is small, the ON-state voltage drop $V_{ON}$ becomes high, while if it is too high, the latch-up current $I_L$ is reduced. When the ON-state voltage drop is set at 1.5V, the dose of n-emitter layer must be not less than 1.25 $\times$ $10^{13}$ cm$^{-2}$ as compared with that of p-base layer, while if latch-up current $I_L$ is set at 300 Acm$^{-2}$, the dose of n-emitter layer must be not more than 1 $\times$ $10^{14}$ cm$^{-2}$. If

the dose thereof is too high, the threshold voltage of second MOSFET 14 and third MOSFET 13p exceed 10V and this leads to an increase of the gate-control voltage. Thus, the dose of n-emitter layer 5 is not less than that of p-base layer 4 and not more than 1 $\times$ $10^{14}$ cm$^{-2}$.

Embodiment 2

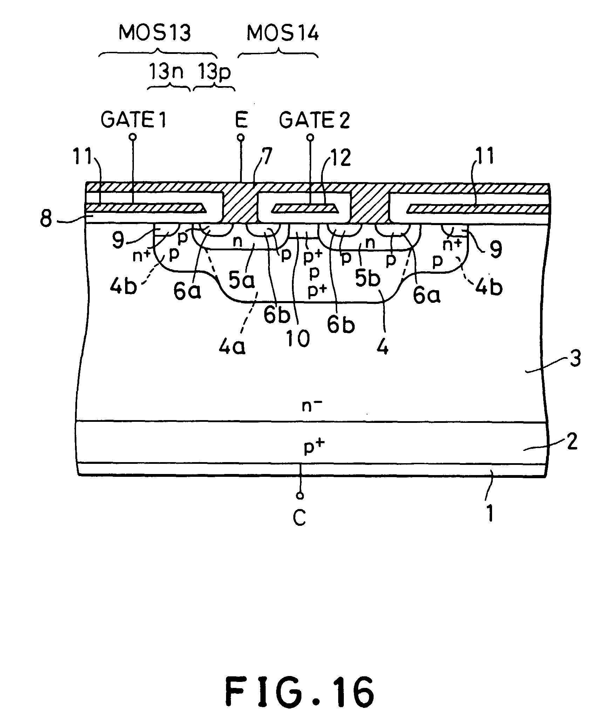

Fig. 16 shows the structure of a semiconductor device equipped with a double gate comprising first and second gates according to the second embodiment of the present invention. The structure and operation of the semiconductor device according to this embodiment are approximately identical to those of the semiconductor device according to the first embodiment and, therefore, parts common thereto are represented by the same reference numerals and the explanation thereof is herein omitted. The semiconductor device according to the second embodiment likewise comprise a $p^+$ -substrate as a collector layer 2 on the back face of which a collector electrode 1 is formed, an $n^-$ -base layer 3 formed on the collector layer and a p-base layer 4 formed on the surface of base layer 3. An $n^+$ -buffer layer may be placed between collector layer 2 and base layer 3. In the device of this embodiment, base layer 4 comprises a relatively deep $p^+$ -type well 4a positioned at the central portion and a p-type peripheral layer (channel portion) 4b which is thinner than the $p^+$ -type well and formed around the $p^+$ -type well. As in embodiment 1, n-emitter layers 5a and 5b $p^+$ -emitter layers 6a and 6b are formed on the inner surface of this p-base layer 4. Further, a first gate electrode 11 constitutes first and third MOSFET's 13n and 13p, and a second gate electrode 12 constitutes a second MOSFET 14. In the device of this embodiment, a counter-doping layer 9 which is doped with an $n^+$ -type dopant to reduce the channel length is formed on the surface of $n^-$ -base layer 3 which constitutes MOS 13n. A high -concentration doping layer 10 which is doped with a $p^+$ -type dopant is formed on the surface of p-base layer 4 behind gate electrode 12 constituting second MOS 14.

In the device of this embodiment having such a structure, if a voltage is applied to a gate electrode 11 of MOS 13 and gate electrode 12 of MOS 14, an emitter electrode 7 is electrically connected to $n^-$ -base layer 3 through n-emitter layer 5a, an $n^+$ -accumulation layer formed on the emitter layer, an n-inversion layer formed on the surface of p-base layer 4 and counter-doping layer 9. Thus, the channel length of an n-type channel formed during the ON state can be reduced by the action of counter doping layer 9 when a thyristor 15 (Fig. 7) is in the ON state. More specifically, the turn-off and turn-off characteristics of the device of this embodiment can be improved because of the enhanced operation speed of first MOSFET 13n.

Moreover, if a negative voltage is applied to gate electrode 12 of second MOS 14 starting from this ON state, the surface of n-emitter layer 5a just under gate electrode 12 is inverted to p-type one and a short circuit is formed between p-base layer 4, $p^+$ -high concentration doping layer 10, the surface of n-emitter layer 5a which is inverted to p-type one and $p^+$ -emitter layer 6a. As a result, the thyristor operation is disappeared and the device is transferred to its transistor state, like the operating condition of IGBT, in which only the transistor $Q_{pnp}$ operates. The transistor comprises p-base layer 4, $n^-$ -base layer 3 and $p^+$ -collector layer 2. Since the device of this embodiment comprises $p^+$ -high concentration doping layer 10, a large hole current can be obtained at an instance when the thyristor state is transferred to the transistor state. Thus, the time required for transferring the thyristor state to the transistor state can be shortened.

Incidentally, $P^+$ -type well 4a is formed for the following reason. The incorporation of $P^+$ -type well 4a into this device makes it possible to increase the level of the latch-up current during transistor operation and to increase the controllable current. In this respect, if the dose is too high, the ON-state voltage drop of the thyristor is increased. Therefore, the dose must be optimized. The dose of $P^+$ -type well 4a hereinafter be closely examined in cases wherein it is formed through surface-diffusion or it is formed as a buried layer.

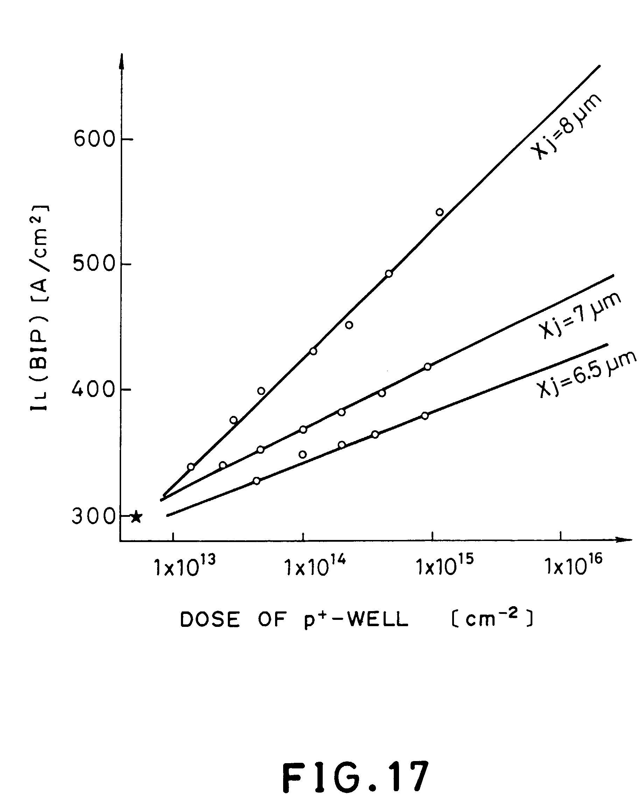

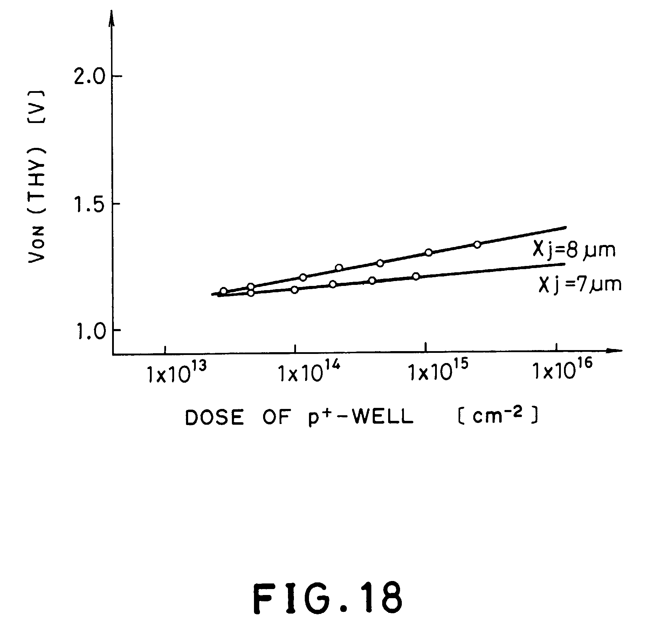

First, it is closely examined in the case wherein the $P^+$ -type well is formed through surface-diffusion. Fig. 17 is a graph illustrating the relation between the dose of the $P^+$ -type well formed through surface-diffusion and the latch-up current (controllable current observed until the latch up phenomenon is caused) in the transistor state, observed when forming a p-type peripheral layer (channel portion) having a diffusion depth of 6μm. In this relation, the diffusion depth $X_j$ of $P^+$ -type well is used as a parameter and an asterisk appearing in the figure represents a value observed when a $P^+$ -type well is not formed. As seen from this figure, the latch-up current increases along with an increase of the dose irrespective of the values of the diffusion depth $X_j$ . The latch-up current $I_L$ observed when the $P^+$ -type well is not formed is about 300 Acm$^{-2}$ and thus a sufficient resistance to latch up can be obtained at a dose of not less than $1 \times 10^{13}$ cm$^{-2}$ . On the other hand, Fig. 18 is a graph illustrating the relation between the dose of the $P^+$ -type well formed through the surface diffusion and the ON-state voltage drop in the transistor state, observed when a p-type peripheral layer (channel portion) having a diffusion depth of 6μm. When $X_j$ is 8μm, the ON-state voltage drop increases along with an increase of the dose, but the rate of change thereof is negligibly small. Therefore, the upper limit of the dose may be determined on the basis of the productivity such as ion-implantation time and the practical upper limit thereof is desirably $5 \times 10^{15}$ cm$^{-2}$. Accordingly, the dose of $P^+$ -type well is desirably not less than $1 \times 10^{13}$ cm$^{-2}$ and not more than $5 \times 10^{15}$ cm$^{-2}$.

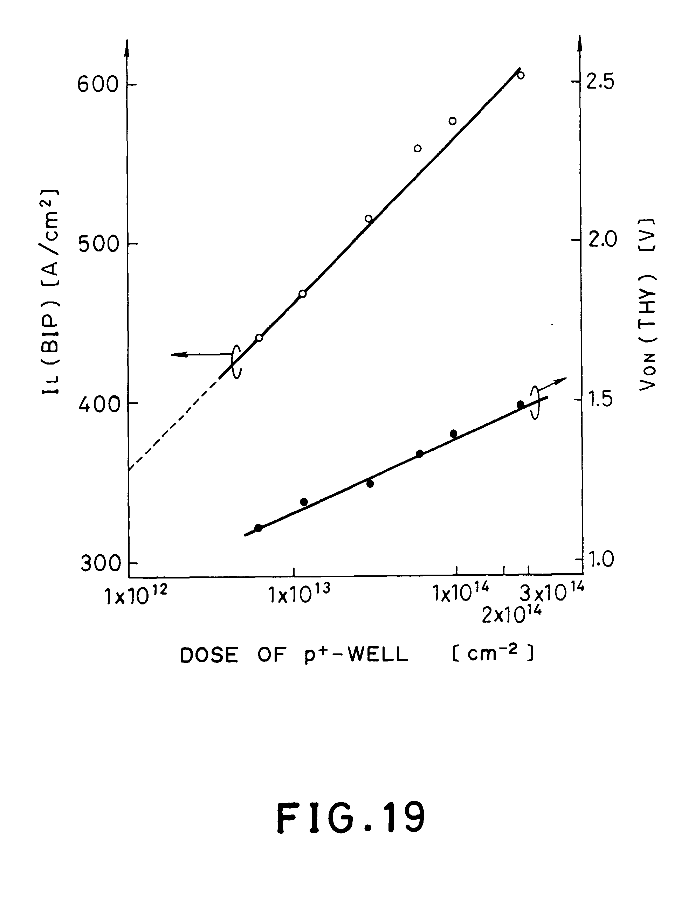

Then $P^+$ -type well 4a formed as a buried layer will be closely examined. Fig. 19 is a graph illustrating the relation between the dose of the $P^+$ -type well formed as a buried layer and the ON-state voltage drop in the thyristor state or the latch-up current (controllable current observed until the latch-up phenomenon takes place) in the transistor state, observed when $P^+$ -type well 4a is formed as buried layer. As seen from this figure, the latch-up current $I_L$ increases along with an increase in the dose. When the dose is $1 \times 10^{12}$ cm$^{-2}$, the latch-up current $I_L$ is about 350 Acm$^{-2}$ which can provide sufficient resistance to latch up. The ON-state voltage drop $V_{ON}$ likewise increases as the dose is increased and the ON-state voltage drop $V_{ON}$ is about 1.5V at a dose of $3 \times 10^{14}$ cm$^{-2}$. Thus, the dose required for forming $P^+$ -type well 4a as a buried layer is desirably not less than $1 \times 10^{12}$ cm$^{-2}$ and not more than $3 \times 10^{14}$ cm$^{-2}$.

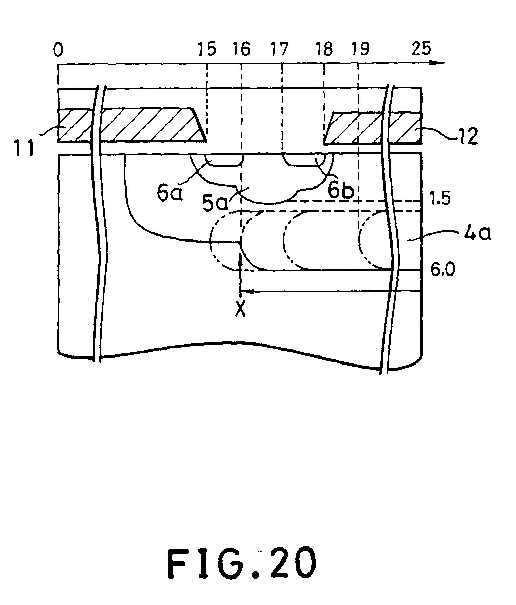

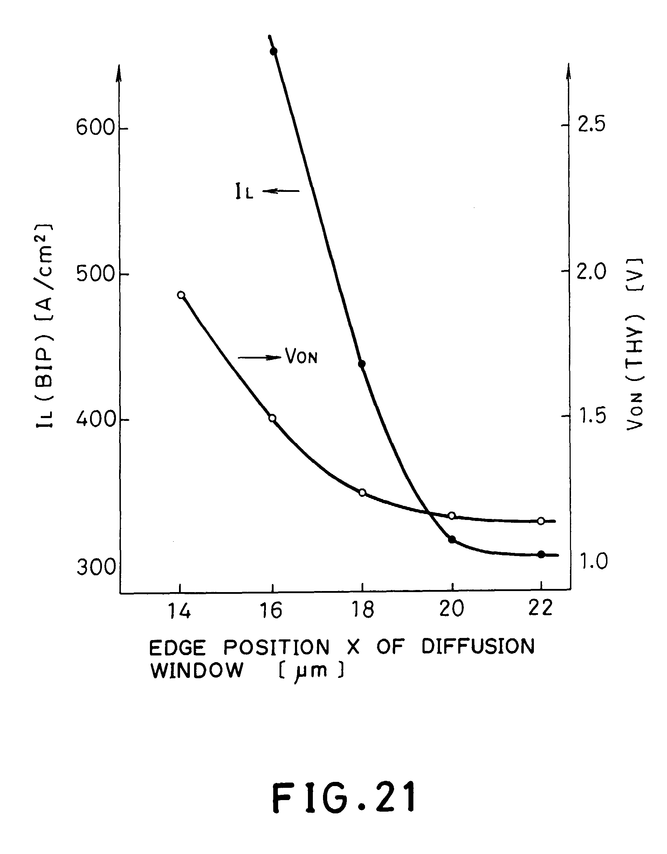

The optimum position of the diffusion window when $P^+$ -type well 4a is formed as buried layer can be determined in the following manner. As shown in Fig. 20, a distance from the central point of second gate electrode 12 to the central point of first gate electrode 11 which is taken as the origin is assumed to be 25μm and the edge position of the diffusion window is denoted by X. Fig. 21 is a graph illustrating the relation between the edge position X of the diffusion window and the ON-state voltage drop in the thyristor state or the latch-up current (controllable current observed until the latch-up phenomenon takes place) in the transistor state. The nearer the edge position X of the diffusion window to gate electrode 11, the higher the latch-up current $I_L$ and correspondingly the higher the ON-state voltage drop $V_{ON}$. When the ON-state voltage drop $V_{ON}$ is assumed to be 1.5V, X is equal to 16μm and the edge position of the diffusion window is positioned near the inner edge of $P^+$ -emitter layer 6a. Thus, it is necessary to position the edge of the diffusion window at a point near the inner edge of $P^+$ -emitter layer 6a and on the side of gate electrode 12 in order to obtain a large controllable current while maintaining the ON-state voltage drop to a level of not more than 1.5V.

Embodiment 3

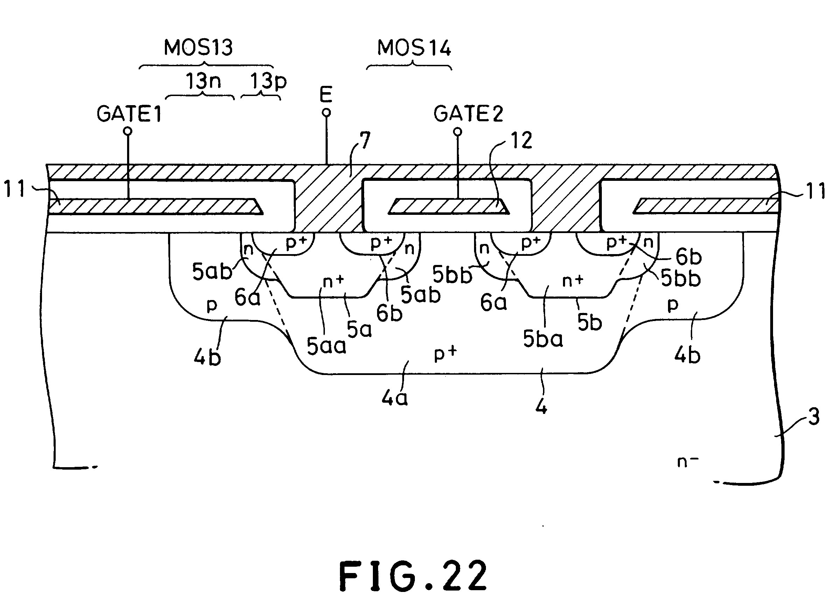

Fig. 22 is a cross sectional view showing the structure of the semiconductor device according to Embodiment 3 of the present invention which is provided with a double gate comprising first and second gates. The structure and operation of the semiconductor device of this embodiment are approximately identical to those of the semiconductor device according to the second embodiment, and , therefore, parts common thereto are represented by the same reference numerals and the explanation thereof is herein omitted. A p-base layer 4 is formed on the surface of an n-base layer 3. Base layer 4 comprises a deep $P^+$ -type well layer 4a formed by the diffusion method or formed as a buried layer and a p-type peripheral layer (channel portion) 4b which is shallower than $P^+$ -type well layer 4a and formed around the center of the P+ -type well and n-emitter layers 5a and 5b and P+ -emitter layers 6a and 6b are formed on the inner surface of p-base layer 4 as observed in the second embodiment. Further a first gate electrode 11 constitutes first and third MOSFET's 13n and 13p and a second gate electrode 12 constitutes a second MOSFET 14. In this embodiment, n- emitter layers 5a and 5b each comprises a deep n+ -type well 5aa or 5ba and an n-type peripheral layer 5ab or 5bb which is shallower than the n+ -type well layer and formed around the center of the n+ -type well. The incorporation of an n- emitter layer having such a structure into the device can provide a high latch-up current and a low ON-state voltage drop as will be discussed below.

As in the first and second embodiments, n-emitter layers 5a and 5b form channel regions for second MOSFET 14 and third MOSFET 13p respectively and, therefore, it is necessary to lower the concentrations of n-emitter layers 5a and 5b to some extent in order to reduce the threshold voltage of MOS's and to simultaneously obtain a high latch up current, while it is necessary to increase the concentrations of n-emitter layer 5a and 5b to some extent in order to reduce the ON-state voltage drop during the thyristor operation. In the first embodiment, the concentrations of n-emitter layers 5a and 5b are set at optimum values in order to simultaneously satisfy these two requirements. According to this embodiment, however, these two requirements can always be satisfied bu the use of deep n+ -type well layers 5aa and 5ba and shallow n-type peripheral layers 5ab and 5bb. More specifically, the presence of deep n+ -type well layers 5aa and 5ba permits the reduction of the ON-state voltage drop during the thyristor operation and the presence of shallow n-type peripheral layers 5ab and 5bb allows the lowering of the surface concentrations. Therefore, a high latch-up current can be obtained. Moreover, the presence of n+ -type well layers 5aa and 5ba is also effective for the achievement of a good ohmic contact with an emitter electrode 7.

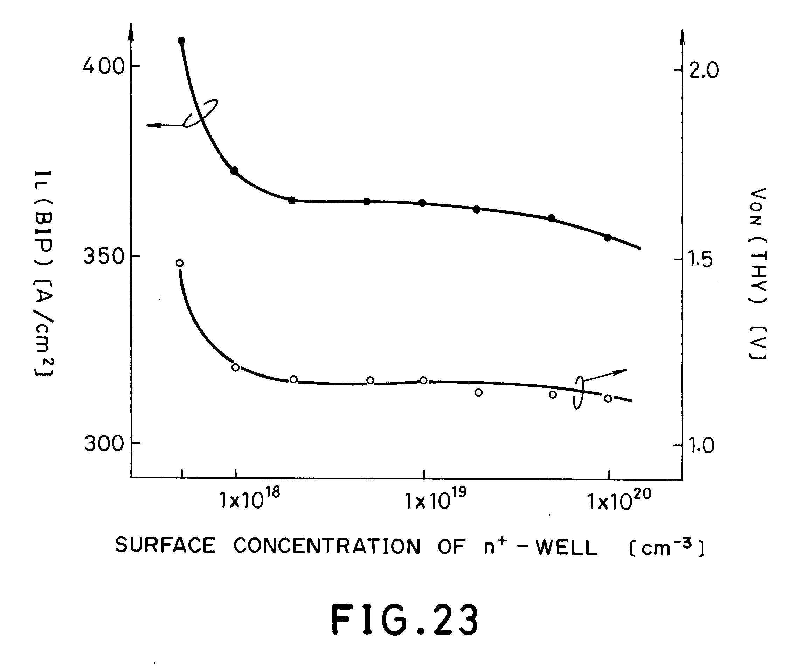

Fig. 23 is a graph illustrating the relation between the surface concentration of the n+ -type well layer and the ON-state voltage drop in the thyristor state or the latch-up current (controllable current observed until the latch-up phenomenon is caused) in the transistor state, observed when an n+ -type well layer has a diffusion depth of 1.5μm. As seen from this figure, the surface concentration of the n+ -type well layer must be not less than $5 \times 10^{17}$ cm$^{-3}$ in order to maintain a high latch-up current $I_L$ and to reduce the ON-state voltage drop $V_{ON}$ (not more than 1.5V). It is difficult for the present semiconductor processing techniques to achieve a concentration of not less than $5 \times 10^{20}$ cm$^{-3}$ and such a high concentration is not needed. Therefore, the surface concentration of n+ -type well layer is desirably not less than $5 \times 10^{17}$ cm$^{-3}$ and not more than $5 \times 10^{20}$ cm$^{-3}$.

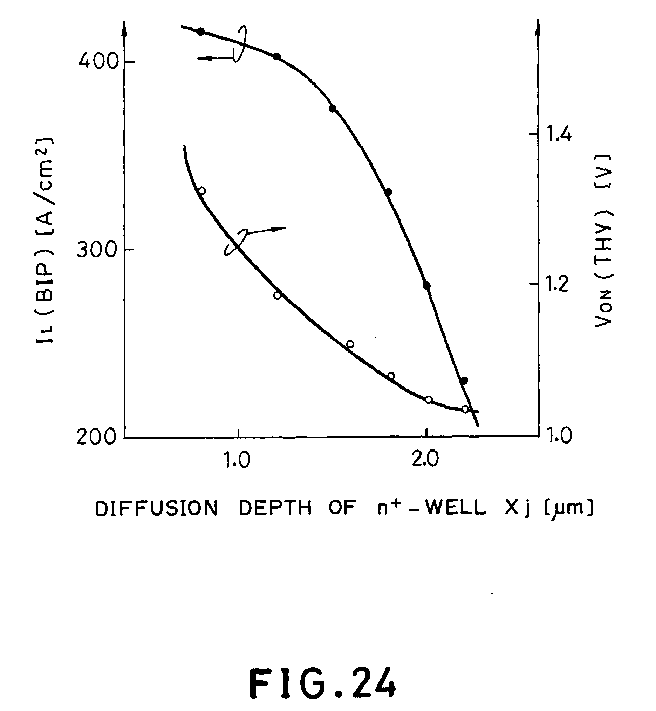

Fig. 24 is a graph illustrating the relation between the diffusion depth of the n+ -type well layer and the ON-state voltage drop in the thyristor state or the latch-up current (controllable current observed until the latch-up phenomenon is caused) in the transistor state, observed when the surface concentration of the n+ -type well layer is set at $1 \times 10^{17}$ cm$^{-3}$ and the diffusion depth of the n-type peripheral layer is set at 0.6μm. As seen from this figure, as the diffusion depth of the n+ -type well layer approaches that the n-type peripheral layer (channel portion), the ON-state voltage drop $V_{ON}$ correspondingly increases. Moreover, if the diffusion depth of the n+ -type well layer is not less than 1.5μm, latch up current $I_L$ approximately linearly decreases. The diffusion depth of the n+ -type well layer must be not less than the diffusion depth of the n-type peripheral layer (channel portion) and not more than 1.9μm in order to obtain a latch-up current of at least about 300 Acm$^{-2}$.

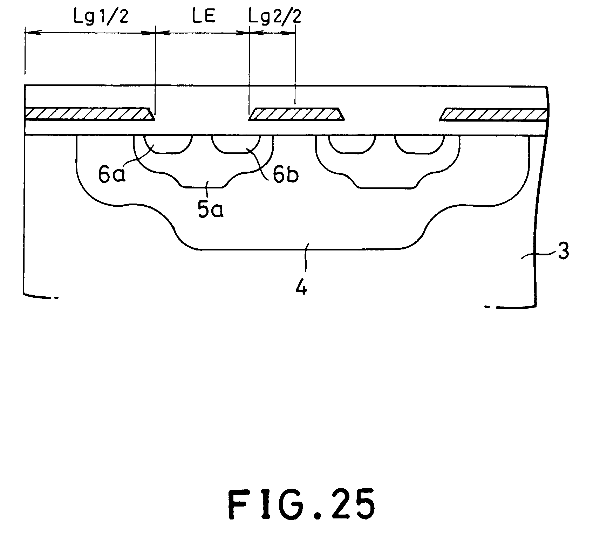

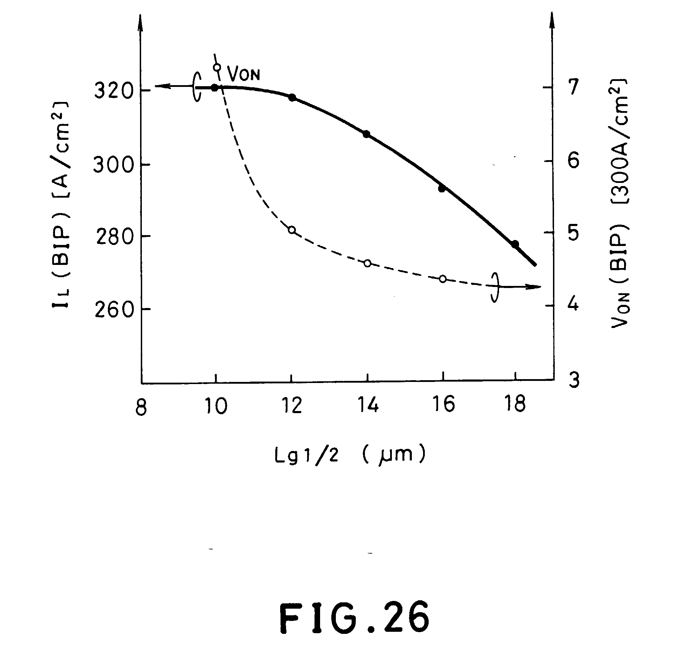

Then, as shown in Fig. 25, the gate length $L_{g1}$ of first gate electrode 11, the gate length $L_{g2}$ of second gate electrode 12 and the contact length $L_E$ of emitter electrode 7 are determined. Fig. 26 is a graph illustrating the relation between the gate length $L_{g1}$ and the latch-up current in the transistor state or the ON-state voltage drop in the transistor state, observed when the gate length $L_{g2}$ is 4μm. As seen from this figure, when $L_{g1}/2$ is 10μm, the ON-state voltage drop $V_{ON}$ in the transistor state is about 7 V and, therefore, the ON-state voltage drop is too high when the gate length is less than that value and cannot be practically acceptable. On the other hand, if the gate length $L_{g1}$ is further increased, the ON-state voltage drop is reduced and the latch-up current is also reduced. $L_{g1}/2$ must be controlled to a level of not more than 15 μm to ensure a latch-up current $I_L$ of about 300 Acm$^{-2}$. Thus, the gate length of first gate electrode 11 is desirable not less than 20 μm and not more than 30 μm. Incidentally, if the gate length is not more than 8 μm, the transistor cannot be in the On state.

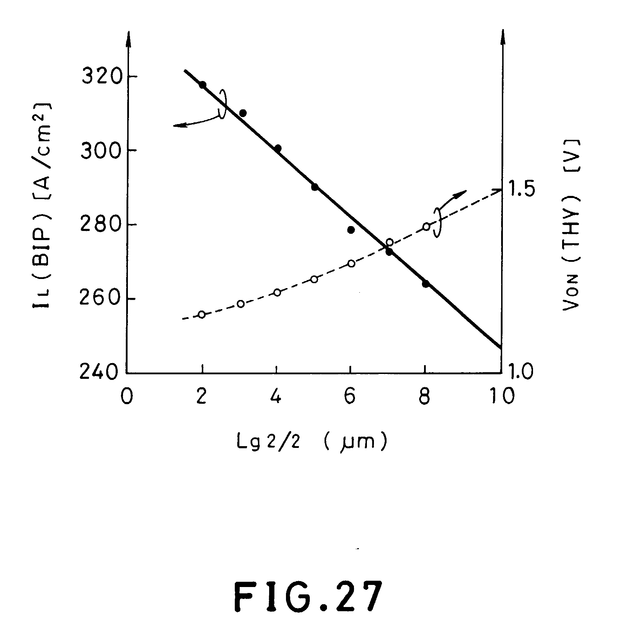

Fig. 27 is graph illustrating the relation between the gate length $L_{g2}$ and the latch-up current in the transistor state state or the ON-state voltage drop in the thyristor state, observed when the gate length $L_{g1}$ is 15 μm. In this case, p-base layer 4b has a surface concentration of $3 \times 10^{17}$cm$^{-3}$ and a diffusion depth of 8 μm and n-emitter layer 5ab has a surface concentration of $5 \times 10^{17}$ cm$^{-3}$ and a diffusion depth of 1 μm. Moreover, a counter-doping layer is formed as in the case of Embodiment 2. This figure clearly indicates that if $L_{g2}/2$ is not more than 4 μm, the latch-up current $I_L$ is not less than 300 Acm$^{-2}$. Moreover, if $L_{g2}$ is reduced, the ON-state voltage drop is likewise reduced and thus the lower limit of the gate length does not come into question. However, the fine processing on the order of submicron size is unfavorable in view of cost or the like and thus the lower limit is desirable 1 μm. Accordingly, the gate length $L_{g2}$ of second gate electrode 12 is desirable not less than 1 μm and not more than 8 μm.

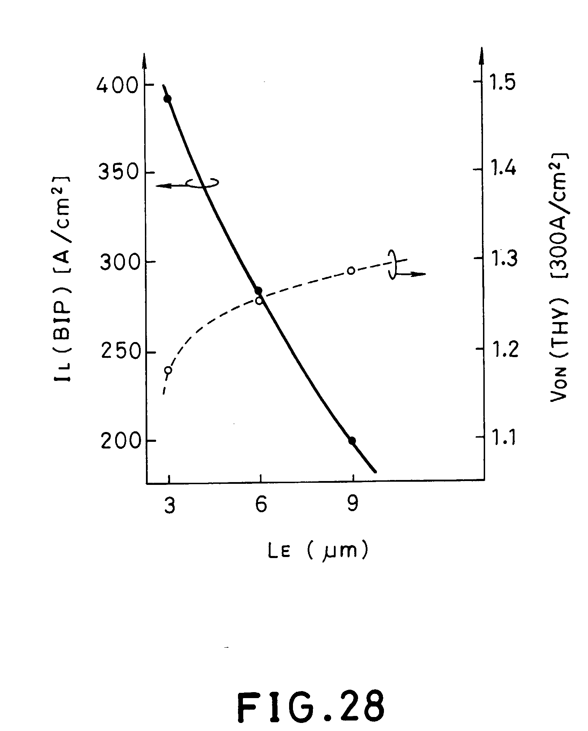

Fig. 28 is a graph illustrating the relation between the contact length $L_E$ of emitter electrode 7 and the latch-up current in the transistor state or the ON-state voltage drop in the thyristor state, wherein p-base layer 4b has a surface concentration of $2.7 \times 10^{16} \mathrm{cm}^{-3}$ and a diffusion depth of $6\,\mu m$, n-emitter layer 5ab has a surface concentration of $1.0 \times 10^{17} \mathrm{cm}^{-3}$ and a diffusion depth of $1.0\,\mu m$ and n + -type well layer 5a has a surface concentration of $1.0 \times 10^{19} \mathrm{cm}^{-3}$ and a diffusion depth of $1.5\,\mu m$. This figure clearly indicates that the latch up current $I_L$ is reduced as the contact length $L_E$ increases. Since the latch up current $I_L$ is about 300 $\mathrm{Acm}^{-2}$ when $L_E$ is $6\mu m$, the upper limit thereof is desirable $6\mu m$. The lower limit thereof is not critical, but the fine processing on the order of submicron size is unfavorable in view of cost or the like and thus the lower limit is desirable $1\mu m$. Accordingly, the contact length $L_E$ of emitter electrode 7 is desirably not less than $1\,\mu m$ and not more than $6\,\mu m$.

In this embodiment 2 and the foregoing embodiment 1, the devices have been explained on the basis of vertical devices in which the emitter electrode and the collector electrode are positioned on the surface and back face of the device respectively, but the device of the present invention may of course be horizontal type one in which these emitter and collector electrodes are positioned on the same face of the device. In addition, it is also possible to use a substrate of the conductive type opposite to that so the semiconductor substrate used in the foregoing embodiments. Furthermore, the structures of the base layers and the emitter layers are not restricted to those adopted in the foregoing embodiments and a variety of other structures may be adopted. The first and second MOS's may of course have a variety of structures other than those explained above.

As has been explained above in detail, the semiconductor device according to the present invention makes it possible to achieve a low ON-state voltage drop like MCT during the ON state and to obtain a short switching time like IGBT during the OFF state through the use of first and second MISFET's. Therefore, the trade off of the switching time and ON-state voltage drop can substantially be improved unlike the conventional power semiconductor devices such as MCT, IGBT and GTO. For instance, the device permits the achievement of a turn-off time of not more than $1\mu$ sec, a fall time of not more than $0.3\mu$ sec and an ON-state voltage drop of the order of 1.0 V/300 $\mathrm{A/cm}^2$. Therefore, the present invention makes it possible to substantially improve the quality of power devices used in devices and/or circuits through which medium and high electric currents can pass and which have medium and high withstand voltages. Moreover, the device of the present invention can operate at a frequency up to about 100 kHz and thus permits the substantial reduction of losses in the high frequency applications. As has been discussed above, the reduction of losses in various kinds of devices and miniaturization thereof which have recently been required from the viewpoint of, in particular, electric power-saving can be accomplished by making use of the device according to the present invention.

## Claims

1. A semiconductor device comprising:

   a collector region (2) of a first conductive type;
   a first base region (3) of opposite second conductive type;
   a second base region (4) of said first conductive type disposed in said first base region (3); and
   a first emitter region (5a,5b) of said second conductive type disposed in said second base region (4), wherein said collector region (2), first base region (3), second base region (4) and first emitter region (5a,5b) define a thyristor (2,3,4,5a,5b);
   a first gate electrode (11) insulated from and extending across said first base region (3), second base region (4), and first emitter region (5a, 5b), to define therewith a first insulated gate transistor (13n); and
   a second gate electrode (12), separate from said first gate electrode (11), insulated from and extending across said second base region (4), first emitter region (5a,5b) and a second emitter region (6b) of said first conductive type disposed in said first emitter region (5a,5b) to define therewith a second insulated gate transistor (14), which semiconductor device is characterised by:
   a third gate electrode (11), coextensive with said first gate electrode (11) insulated from and extending across said second base region (4), first emitter region (5a,5b) and a second emitter region (6a) of said first conductive type disposed in said first emitter region (5a,5b) to define therewith a third insulated gate transistor (13p).

2. A semiconductor device as claimed in claim 1, wherein said second base region (4) is doped at a dose of not less than 2 x $10^{13}$ $\mathrm{cm}^{-2}$ not more than 1 x $10^{14}$ $\mathrm{cm}^{-2}$ and said first emitter region (5a,5b) is doped at a dose equal to or more than that of said second base region (4) and not more than 1 x $10^{14}$ $\mathrm{cm}^{-2}$.

3. A semiconductor device as claimed in either one of claims 1 and 2, wherein said second base region (4) comprises a first conductive type well (4a) and a first conductive type peripheral portion (4b) shallower than said well, of high and of lower dopant dose, respectively.

4. A semiconductor device as claimed in claim 3, wherein said first conductive type well (4a) of high dose is a surface-diffusion having a dose of not less than 1 x $10^{13}$ $\mathrm{cm}^{-2}$ and not more than 5 x $10^{15}$ $\mathrm{cm}^{-2}$.

5. A semiconductor device as claimed in claim 3, wherein said first conductive type well (4a) of high dose is a buried layer having a dose of not less than $1 \times 10^{12}$ cm$^{-2}$ and not more than $3 \times 10^{14}$ cm$^{-2}$.

6. A semiconductor device as claimed in claim 5, wherein an edge (X) of said first conductive type well (4a) is positioned between the inner edge (16) of said second emitter region (6a) of said first insulated gate transistor (13n) and the inner edge (18) of said second gate electrode (12).

7. A semiconductor device as claimed in claim 1, wherein said first emitter region (5a,5b) comprises a second conductive type well (5aa,5ba) having a second conductive type peripheral portion (5ab, 5bb) shallower than said well, of high and of lower dopant dose, respectively.

8. A semiconductor device as claimed in claim 7, wherein the surface dopant concentration of said second conductive type well (5aa,5ba) is not less than $5 \times 10^{17}$ cm$^{-3}$ and not more than $5 \times 10^{20}$ cm$^{-3}$.

9. A semiconductor device as claimed in either one of claims 7 and 8, wherein the diffusion depth of said second conductive type well (5aa,5ba) is not less than the diffusion depth of said second conductive type peripheral portion (5ab,5bb) and not more than 1.9 μm.

10. A semiconductor device as claimed in any one of claims 7 to 9, wherein the gate length of said first gate electrode (11) is not less than 20 μm and not more than 30 μm.

11. A semiconductor device as claimed in any one of claims 7 to 10, wherein the gate length of said second gate (12) is not less than 1 μm and not more than 8 μm.

12. A semiconductor device as claimed in any one of claims 7 to 11, wherein the contact length of an emitter electrode (E) in conductive contact with said emitter regions (5a,5b,6a,6b) is not less than 1 μm and not more than 6 μm.

13. A semiconductor device as claimed in any one of the preceding claims, including a shallow second conductive type region (9) disposed in the surface of said second base region (4) in the region of said first insulated gate transistor (13n).

14. A semiconductor device as claimed in any one of the preceding claims, including a first conductive type region (10) of a high dose at the surface of said second base region (4) in the region of said second insulated gate transistor (14).

15. A thyristor circuit comprising:

a semiconductor device as claimed in any preceding claim; and
gate voltage supply means, connected to said first and third gate electrode (11) and to said second gate electrode (12), adapted to supply respective voltages thereto to turn on said first insulated gate transistor (13n) and to turn off said second and third insulated gate transistors (14,13p) simultaneously, and subsequently to turn on said second insulated gate transistor (14) in advance of turning off said first insulated gate transistor (13n) and turning on said third insulated gate transistor (13p).

16. A method of operating a semiconductor device comprising the following steps:

applying respective collector and emitter supply voltages to the collector region (2) and emitter regions (5a,5b,6a,6b) of the semiconductor device as claimed in any of the preceding claims 1 to 14;
applying respective first gate voltages to the first and second gate electrodes (11,12) to turn on said first insulated gate transistor (13n) and to turn off said second and third gate transistors (14,13p) simultaneously; thereafter, applying a second gate voltage to the second gate electrode (12) to turn on said second insulated gate transistor (14) while the respective first gate voltage is still applied to the first gate electrode (11) maintaining said first insulated gate transistor (13n) on and said third insulated gate transistor (13p) off; and thereafter applying a third gate voltage to the first gate electrode (11) to turn off said first insulated gate transistor (13n) and turn on said third insulated gate transistor (13p) while said second gate voltage is still applied to the second gate electrode (12) maintaining said second insulated gate transistor (14) on.

**Patentansprüche**

1. Halbleiterbauteil, mit:

einer Kollektorzone (2) eines ersten Leitfähigkeitstyps;
einer ersten Basiszone (3) entgegengesetzten Leitfähigkeitstyps;
einer zweiten Basiszone (4) des ersten Leitfähigkeitstyps, die in der ersten Basiszone (3) angeordnet ist; und mit
einer ersten Emitterzone (5a, 5b) des zweiten Leitfähigkeitstyps, die in der zweiten Basiszone (4) angeordnet ist, wobei die Kollektorzone (2), die erste Basiszone (3), die zweite Basiszone (4) und die erste Emitterzone (5a, 5b) einen Thyristor (2, 3, 4, 5a, 5b) festlegen; eine erste Gate-Elektrode (11), die isoliert ist von und sich erstreckt über die erste Basiszone (3), zweite Basiszone (4) und die erste Emitterzone (5a, 5b), um damit einen ersten Transistor (13n) mit isoliertem Gate festzulegen; und mit einer von der ersten Gate-Elektrode (11) separierten, zweiten Gate-Elektrode (12), die isoliert ist von und sich erstreckt über die zweite Basiszone (4), die erste Emitterzone (5a, 5b) und eine zweite Emitterzone (6b) des ersten Leitfähigkeitstyps, die in der ersten Emitterzone (5a, 5b) angeordnet ist, um damit einen Transistor (14) mit isoliertem Gate festzulegen, **gekennzeichnet durch:** eine dritte Gate-Elektrode (11), die mit der ersten Gate-Elektrode (11), die sich deckt mit der ersten Gate-Elektrode (11), die isoliert von und sich erstreckend über die zweite Basiszone (4), die erste Emitterzone (5a, 5b) und die zweite Emitterzone (6a) des ersten Leitfähigkeitstyps, die in der ersten Emitterzone (5a, 5b) angeordnet ist, um damit einen Transistor (13p) mit isoliertem Gate festzulegen.

2. Halbleiterbauteil nach Anspruch 1, dessen zweite Basiszone (4) mit einer Dosis von nicht weniger als $2 \times 10^{13}$ cm$^{-2}$, nicht mehr als $1 \times 10^{14}$ cm$^{-2}$ dotiert ist, und dessen erste Emitterzone (5a, 5b) mit einer Dosis dotiert ist, die ebensogroß oder größer als die der zweiten Basiszone (4) und nicht mehr als $1 \times 10^{14}$ cm$^{-2}$ ist.

3. Halbleiterbauteil nach einem der Ansprüche 1 oder 2, dessen zweite Basiszone (4) eine Mulde (4a) des ersten Leitfähigkeitstyps und einen peripheren Abschnitt (4b) des ersten Leitfähigkeitstyps aufweist, der (4b) flacher als die Mulde ist und eine hohe bzw. niedrige Dotierungsdosis aufweist.

4. Halbleiterbauteil nach Anspruch 3, dessen Mulde (4a) des ersten Leitfähigkeitstyps hoher Dotierung eine Oberflächendiffusion mit einer Dosis nicht geringer als $1 \times 10^{13}$ cm$^{-2}$ und nicht größer $5 \times 10^{15}$ cm$^{-2}$ ist.

5. Halbleiterbauteil nach Anspruch 3, dessen Mulde (4a) des ersten Leitfähigkeitstyps hoher Dotierung eine beerdigte Schicht mit einer Dotierung von nicht weniger als $1 \times 10^{12}$ cm$^{-2}$ und nicht mehr als $3 \times 10^{14}$ cm$^{-2}$ ist.

6. Halbleiterbauteil nach Anspruch 5, bei dem eine Kante (X) der Mulde (4a) des ersten Leitfähigkeitstyps zwischen der Innenkante (16) der zweiten Emitterzone (6a) des Transistors (13n) mit isoliertem Gate und der Innenkante (18) der zweiten Gate-Elektrode (12) positioniert ist.

7. Halbleiterbauteil nach Anspruch 1, dessen erste Emitterzone (5a, 5b) eine Mulde (5aa, 5ba) des zweiten Leitfähigkeitstyps mit einem peripheren Abschnitt (5ab, 5bb) des zweiten Leitfähigkeitstyps enthält, der flacher als die Mulde ist und eine hohe bzw. niedrige Dotierungsdosis aufweist.

8. Halbleiterbauteil nach Anspruch 7, bei dem die Oberflächendotierungskonzentration der zweiten Mulde (5aa, 5ba) des zweiten Leitfähigkeitstyps nicht geringer als $5 \times 10^{17}$ cm$^{-3}$ und nicht höher als $5 \times 10^{20}$ cm$^{-3}$ ist.

9. Halbleiterbauteil nach einem der Ansprüche 7 und 8, bei dem die Diffusionstiefe der Mulde (5aa, 5ba) des zweiten Leitfähigkeitstyps nicht geringer als die Diffusionstiefe des peripheren Abschnitts (5ab, 5bb) ist und nicht mehr als 1,9 μm beträgt.

10. Halbleiterbauteil nach einem der Ansprüche 7 bis 9, bei dem die Gate-Länge der ersten Gate-Elektrode (11) nicht weniger als 20 μm und nicht mehr als 30 μm beträgt.

11. Halbleiterbauteil nach einem der Ansprüche 7 bis 10, bei dem die Gate-Länge des zweiten Gates (12) nicht weniger als 1 μm und nicht mehr als 8 μm beträgt.

12. Halbleiterbauteil nach einem der Ansprüche 7 bis 11, bei dem die Kontaktlänge einer Emitterelektrode (E) in leitendem Kontakt mit den Emitterzonen (5a, 5b, 6a, 6b) nicht weniger als 1 μm und nicht mehr als 6 μm beträgt.

13. Halbleiterbauteil nach einem der vorstehenden Ansprüche, das eine flache Zone (9) des zweiten Leitfähigkeitstyps enthält, die in der Oberfläche der zweiten Basiszone (4) im Gebiet des ersten Transistors (13n) mit isoliertem Gate angeordnet ist.

14. Halbleiterbauteil nach einem der vorstehenden Ansprüche, das eine Zone (10) des ersten Leitfähigkeitstyps hoher Dotierung an der Oberfläche der zweiten Basiszone (4) im Gebiet des zweiten Transistors (14) mit isoliertem Gate enthält.

15. Thyristorschaltung, mit:

einem Halbleiterbauteil nach einem der vorstehenden Ansprüche; und mit Gate-Spannungsanlegemitteln, die mit der ersten und dritten Gate-Elektrode (11) und mit der zweiten Gate-Elektrode (12) verbunden sind, und die der Lieferung jeweiliger Spannungen an diese dienen, um den ersten Transistor (13n) mit isoliertem Gate leitend zu schalten und den zweiten und dritten Transistor (14, 13p) gleichzeitig zu sperren und danach den zweiten Transistor (14) mit isoliertem Gate leitend zu schalten, bevor der erste Transistor (13n) mit isoliertem Gate gesperrt und der dritte Transistor (13p) mit isoliertem Gate leitend geschaltet wird.

16. Verfahren zum Betrieb eines Halbleiterbauteils, mit den Verfahrensschritten:

Anlegen jeweiliger Kollektor- und Emitter-Versorgungsspannungen an die Kollektorzone (2) und Emitterzonen (5a, 5b, 6a, 6b) des Halbleitersbauteils nach einem der vorstehenden Ansprüche 1 bis 14;
Anlegen jeweiliger erster Gatespannungen an die erste und zweite Gate-Elektrode (11, 12), um den ersten Transistor mit isoliertem Gate (13n) leitend zu schalten und den zweiten und dritten Gate-Transistor (14, 13p) gleichzeitig zu sperren; danach Anlegen einer zweiten Gate-Spannung an die zweite Gate-Elektrode (12), um den zweiten Transistor (14) mit isoliertem Gate leitend zu schalten, während die jeweilige erste Gatespannung noch an der ersten Gate-Elektrode (11) anliegt, wodurch der erste Transistor (13n) mit isoliertem Gate leitend gehalten und der dritte Transistor (13p) gesperrt gehalten wird; und danach Anlegen einer dritten Gate-Spannung an die erste Gate-Elektrode (11), um den ersten Transistor (13n) mit isoliertem Gate zu sperren und den dritten Transistor (13p) mit isoliertem Gate leitend zu schalten, während die zweite Gatespannung noch an der zweiten Gate-Elektrode (12 ) anliegt, wodurch der zweite Transistor mit isoliertem Gate leitend gehalten wird.

**Revendications**

1. Dispositif semi-conducteur comprenant :

une région (2) de collecteur d'un premier type de conductivité ;
une première région (3) de base d'un second type de conductivité opposé ;
une seconde région (4) de base du premier type de conductivité disposée dans la première région (3) de base ; et
une première région (5a, 5b) d'émetteur du second type de conductivité, disposée dans la seconde région (4) de base, dans lequel la région (2) de collecteur, la première région (3) de base, la seconde région (4) de base et la première région (5a,5b) d'émetteur définissent un thyristor (2,3,4,5a,5b) ;
une première électrode (11) de grille isolée de la première région (3) de base, de la seconde région (4) de base et de la première région (5a, 5b) d'émetteur et s'étendant transversalement à celles-ci, pour définir avec celles-ci un premier transistor (13n) à grille isolée ; et
une seconde électrode (12) de grille, séparée de la première électrode (11) de grille, isolée la seconde région (4) de base, de la première région (5a,5b) d'émetteur et d'une seconde région (6b) d'émetteur du premier type de conductivité, disposée dans la première région (5a, 5b) d'émetteur, et s'étendant transversalement à celles-ci pour définir avec celles-ci un second transistor (14) à grille isolée, lequel dispositif à semi-conducteur est caractérisé par :
une troisième électrode (11) de grille, coextensive avec la première électrode (11) de grille isolée de la seconde région (4) de base, de la première région (5a,5b) d'émetteur et d'une seconde région (6a) d'émetteur du premier type de conductivité, disposée dans la première région (5a,5b) d'émetteur et s'étendant transversalement à celles-ci pour définir avec elles un troisième transistor (13p) à grille isolée.

2. Dispositif semi-conducteur selon la revendication 1, dans lequel la seconde région (4) de base est dopée à une dose non inférieure à $2 \times 10^{13}$ cm$^{-2}$ et non supérieure à $1 \times 10^{14}$ cm$^{-2}$, et la première région (5a,5b) d'émetteur est dopée à une dose égale ou supérieure à celle de la seconde région (4) de base et non supérieure à $1 \times 10^{14}$ cm$^{-2}$.

3. Dispositif semi-conducteur selon l'une quelconque des revendications 1 et 2, dans lequel la seconde région (4) de base comprend un puits (4a) d'un premier type de conductivité et une partie (4b) périphérique d'un premier type de conductivité moins profonde que le puits, ayant respectivement des doses de dopant élevée et plus faible.

4. Dispositif semi-conducteur selon la revendication 3, dans lequel le puits (4a) du premier type de conductivité à dose élevée est une diffusion de surface ayant une dose non inférieure à $1 \times 10^{13}$ cm$^{-2}$ et non supérieure à $5 \times 10^{15}$ cm$^{-2}$.

5. Dispositif semi-conducteur selon la revendication 3, dans lequel le puits (4a) du premier type de conductivité à dose élevée est une couche enterrée ayant une dose non inférieure à $1 \times 10^{12}$ cm$^{-2}$ et non supérieure à $3 \times 10^{14}$ cm$^{-2}$.

6. Dispositif semi-conducteur selon la revendication 5, dans lequel un bord (X) du puits (4a) du premier type de conductivité est positionné entre le bord (16) intérieur de la seconde région (6a) d'émetteur du premier transistor (13n) à grille isolée et le bord (18) intérieur de la seconde électrode (12) de grille.

7. Dispositif semi-conducteur selon la revendication 1, dans lequel la première région (5a,5b) d'émetteur comprend un puits (5aa, 5ba) d'un second type de conductivité comportant une partie (5ab, 5bb) périphérique d'un second type de conductivité moins profonde que le puits, ayant respectivement des doses de dopant élevée et plus faible.

8. Dispositif semi-conducteur selon la revendication 7, dans lequel la concentration superficielle en dopant du puits (5aa,5ba) du second type de conductivité n'est pas inférieure à $5 \times 10^{17}$ cm$^{-3}$ et n'est pas supérieure à $5 \times 10^{20}$ cm$^{-3}$.

9. Dispositif semi-conducteur selon l'une quelconque des revendications 7 et 8, dans lequel la profondeur de diffusion du puits (5aa,5ba) du second type de conductivité n'est pas inférieure à la profondeur de diffusion de la partie (5ab,5bb) périphérique du second type de conductivité et n'est pas supérieure à 1,9 µm.

10. Dispositif semi-conducteur selon l'une quelconque des revendications 7 à 9, dans lequel la longueur de grille de la première électrode (11) de grille n'est pas inférieure à 20 µm et n'est pas supérieure à 30 µm.

11. Dispositif semi-conducteur selon l'une quelconque des revendications 7 à 10, dans lequel la longueur de grille de la seconde grille (12) n'est pas inférieure à 1 µm et n'est pas supérieure à 8 µm.

12. Dispositif semi-conducteur selon l'une quelconque des revendications 7 à 11, dans lequel la longueur de contact d'une électrode (E) d'émetteur, en contact conducteur avec les régions (5a, 5b, 6a, 6b) d'émetteur n'est pas inférieure à 1 µm et n'est pas supérieure à 6 µm.

13. Dispositif semi-conducteur selon l'une quelconque des revendications précédentes, comportant une région (9) peu profonde d'un second type de conductivité, disposée à la surface de la seconde région (4) de base dans la région du premier transistor (13n) à grille isolée.

14. Dispositif semi-conducteur selon l'une quelconque des revendications précédentes, comportant une région (10) d'un premier type de conductivité ayant une dose élevée à la surface de la seconde région (4) de base, dans la région du second transistor (14) à grille isolée.

15. Circuit à thyristor comprenant :

un dispositif semi-conducteur selon l'une quelconque des revendications précédentes ; et des moyens d'application de tension de grille, connectés aux première et troisième électrodes (11) de grilles et à la seconde électrode (12) de grille, conçus pour fournir à celles-ci des tensions respectives afin de rendre passant le premier transistor (13n) à grille isolée et de rendre simultanément non passants les second et troisième transistors (14,13p) à grille isolée, puis pour rendre passant le second transistor (14) à grille isolée avant de rendre non passant le premier transistor (13n) à grille isolée et de rendre passant le troisième transistor (13p) à grille isolée.

16. Procédé pour faire fonctionner un dispositif semi-conducteur comprenant les étapes suivantes :

l'application de tensions d'alimentation de collecteur et d'émetteur respectives à la région (2) de collecteur et aux régions (5a,5b,6a,6b) d'émetteur du dispositif semi-conducteur selon l'une quelconque des revendications 1 à 14 précédentes ; l'application de premières tensions de grilles respectives aux première et seconde électrodes (11,12) de grilles pour rendre passant le premier transistor (13n) à grille isolée et rendre simultanément non passants les second et troisième transistors (14,13p) à grille ; puis l'application d'une seconde tension de grille à la seconde électrode (12) de grille pour rendre passant le second transistor (14) à grille isolée pendant que la première tension de grille respective est encore appliquée à la première électrode (11) de grille en maintenant passant le premier transistor (13n) à grille isolée et non passant le troisième transistor (13p) à grille isolée ; puis l'application d'une troisième tension de grille à la première électrode (11) de grille pour rendre non passant le premier transistor (13n) à grille isolée et rendre passant le troisième transistor (13p) à grille isolée pendant que la seconde tension de grille est encore appliquée à la seconde électrode (12) de grille en maintenant à l'état passant le second transistor (14) à grille isolée.

FIG.1 (PRIOR ART)

FIG.2 (PRIOR ART)

17

FIG.3 (PRIOR ART)

**FIG.4** (PRIOR ART)

**FIG.5** (PRIOR ART)

FIG.6

# FIG.7

Qnpn

Qpnp

15

Qnpn

Qpnp

15

GATE 2
MOS14

MOS13n

E
7

GATE 1
MOS13p

C
1

**FIG. 8**

FIG.9

GATE ELECTRODE 11

(+)

0

(−)

GATE ELECTRODE 12

(+)

0

(−)

OFF | THYRISTOR ON | OFF | THYRISTOR ON | OFF

TRANSISTOR ON | TRANSISTOR ON

TIME

EP 0 555 047 B1

THYRISTOR OPERATING

# FIG.10A

TRANSISTOR OPERATING

# FIG.10B

FIG.11A

FIG.11B

EP 0 555 047 B1

FIG.12

FIG.13

FIG.14

FIG.15

FIG.16

FIG.17

FIG.18

FIG.19

FIG.20

# FIG.21

FIG.22

EP 0 555 047 B1

FIG.23

FIG.24

FIG.25

FIG.26

FIG.27

FIG.28